# EUROPEAN PATENT APPLICATION

(11) **EP 4 804 774 A1**
(43) Date of publication of application: **09.09.2026**
(21) Application number: 26162650.1
(22) Date of filing: 05.03.2026
(51) Int. Cl.: H10K 59/131

(54) **DISPLAY DEVICE, ELECTRONIC DEVICE, AND METHOD FOR MANUFACTURING DISPLAY DEVICE**

(30) Priority: 06.03.2025 KR 20250028607; 23.04.2025 KR 20250052793
(71) Applicant: Samsung Display Co., Ltd., Yongin-si, Gyeonggi-do 17113 (KR)
(72) Inventor: Hwang, Do Yeon, Yongin-si, Gyeonggi-do (KR); Nam, Hyun Woo, Yongin-si, Gyeonggi-do (KR); Bang, Hyun Chol, Yongin-si, Gyeonggi-do (KR); Yeo, In Hyeok, Yongin-si, Gyeonggi-do (KR); Lee, Dong Yoon, Yongin-si, Gyeonggi-do (KR)
(74) Representative: Gulde & Partner

(57) **Abstract**

A display device includes a circuit board, and a display panel including a substrate including a display area, and a non-display area around the display area, pads electrically connected to the circuit board, and arranged in a pad area of the non-display area that is adjacent to an edge of the substrate, and a circuit layer above the substrate, and including constant voltage supply lines in the pad area, configured to transmit a constant voltage, and electrically connected to some of the pads, constant voltage bus lines in the non-display area between the pad area and the display area, and extending along an edge of the display area, and constant voltage connection lines respectively electrically connected between the constant voltage supply lines and the constant voltage bus lines, and including a first connection portion below, and a second connection portion above, the constant voltage bus lines.

## Description

### BACKGROUND

### 1. Field

The present disclosure relates to a display device, an electronic device including the same, and a method for manufacturing the display device.

### 2. Description of the Related Art

With the advance of information-oriented society, more and more demands are placed on display devices for displaying images in various ways. For example, display devices are employed in various electronic devices such as smartphones, digital cameras, laptop computers, navigation devices, and smart televisions.

The display device may be a flat panel display device, such as a liquid crystal display device, a field emission display device, and a light-emitting display device. Examples of the light-emitting display device may include an organic light-emitting display device including organic light-emitting elements, an inorganic light-emitting display device including inorganic light-emitting elements, such as inorganic semiconductors, and a micro light-emitting display device including micro light-emitting elements.

The organic light-emitting display device displays an image using light-emitting elements, each including a light-emitting layer containing an organic light-emitting material. As described above, the organic light-emitting display device implements image display using a self-light-emitting element, and thus may have relatively superior performance in power consumption, response speed, luminous efficiency, luminance, and wide viewing angle compared to other display devices.

In the display device, a display surface from which light is emitted may include a display area in which an image is displayed, and a non-display area around the display area. Emission areas emitting light with respective luminance and colors may be arranged in the display area.

### SUMMARY

The display device may include a flat plate-shaped display panel from which light for image display is emitted, and at least one circuit board electrically connected to pads of the display panel.

The display panel may include a display area where emission areas are arranged, and a non-display area located around the display area.

The display panel may include constant voltage bus lines arranged in the non-display area and transmitting a constant voltage.

The constant voltage bus lines may be electrically connected to, through constant voltage supply lines and constant voltage connection lines, some of the pads that transmit the constant voltage.

In other words, the constant voltage bus lines are not directly electrically connected to some of the pads.

During the manufacturing process of the display panel, if the constant voltage connection lines are placed later than the constant voltage bus lines and the constant voltage supply lines, at least some of the constant voltage bus lines may become electrically floating before the constant voltage connection lines are placed, becoming vulnerable to static electricity.

As a result, there is a limitation in improving the reliability and yield of the display device because some of the constant voltage bus lines in such a floating state may be easily broken or damaged by static electricity.

In view of the foregoing, aspects of the present disclosure provide a display device capable of reducing or preventing the likelihood of damage or breakage of the constant voltage bus lines, thereby improving reliability and yield, and also provide an electronic device including the display device, and a method for manufacturing the display device.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an aspect of the present disclosure, there is provided a display device including a circuit board, and a display panel including a substrate including a display area, and a non-display area around the display area, pads electrically connected to the circuit board, and arranged in a pad area of the non-display area that is adjacent to an edge of the substrate, and a circuit layer above the substrate, and including constant voltage supply lines in the pad area, configured to transmit a constant voltage, and electrically connected to some of the pads, constant voltage bus lines in the non-display area between the pad area and the display area, and extending along an edge of the display area, and constant voltage connection lines respectively electrically connected between the constant voltage supply lines and the constant voltage bus lines, and including a first connection portion below the constant voltage bus lines, and a second connection portion above the constant voltage bus lines.

The circuit layer may include an interlayer insulating layer above the substrate, a first source-drain conductive layer above the interlayer insulating layer, a first planarization layer covering the first source-drain conductive layer, a second source-drain conductive layer above the first planarization layer, and a second planarization layer covering the second source-drain conductive layer, wherein the constant voltage bus lines and the constant voltage supply lines are in the first source-drain conductive layer, and wherein the second connection portion is in the second source-drain conductive layer.

The display panel may further include an element layer above the circuit layer and including light-emitting elements, wherein the circuit layer further includes light-emitting pixel drivers respectively electrically connected to the light-emitting elements, data lines in the display area, and configured to transmit a data signal, and data supply lines in the non-display area, and respectively electrically connected between others of the pads and the data lines.

The circuit layer may further include a first semiconductor layer above the substrate, a first gate-insulating layer covering the first semiconductor layer, a first gate conductive layer above the first gate-insulating layer, a second gate-insulating layer covering the first gate conductive layer, and a second gate conductive layer above the second gate-insulating layer, wherein the interlayer insulating layer covers the second gate conductive layer.

The data supply lines may be in one of the first gate conductive layer or the second gate conductive layer, wherein the first connection portion is in another one of the first gate conductive layer or the second gate conductive layer.

The data supply lines may be in the first gate conductive layer or the second gate conductive layer, wherein the first connection portion is spaced apart from the data supply lines, and is in the first gate conductive layer or the second gate conductive layer.

The circuit layer may further include a first semiconductor layer above the substrate, a first gate-insulating layer covering the first semiconductor layer, a first gate conductive layer above the first gate-insulating layer, a second gate-insulating layer covering the first gate conductive layer, a second gate conductive layer above the second gate-insulating layer, an additional interlayer insulating layer covering the second gate conductive layer, a second semiconductor layer above the additional interlayer insulating layer, a third gate-insulating layer covering the second semiconductor layer, and a third gate conductive layer above the third gate-insulating layer, wherein the interlayer insulating layer covers the third gate conductive layer, wherein the data supply lines are in the first gate conductive layer or the second gate conductive layer, and wherein the first connection portion is in the third gate conductive layer.

According to an aspect of the present disclosure, there is provided a method for manufacturing a display device, the method including preparing a display panel including a display area, a non-display area around the display area, and pads in a pad area of the non-display area, and attaching a circuit board to the pads, wherein the preparing of the display panel includes preparing a substrate including the display area and the non-display area, arranging first connection portions above the substrate, arranging constant voltage supply lines electrically connected to some of the pads in the pad area, arranging constant voltage bus lines extending along an edge of the display area in the non-display area between the pad area and the display area, and arranging second connection portions overlapping the first connection portions in a thickness direction of the substrate, and electrically connected to the first connection portions.

The constant voltage bus lines may be respectively electrically connected to the constant voltage supply lines through the first connection portions.

The method may further include arranging data supply lines configured to transmit data signals in the non-display area with the first connection portions, at least some of the data supply lines being respectively electrically connected to others of the pads.

The display panel may include a first semiconductor layer above the substrate, a first gate-insulating layer covering the first semiconductor layer, a first gate conductive layer above the first gate-insulating layer, a second gate-insulating layer covering the first gate conductive layer, a second gate conductive layer above the second gate-insulating layer, an interlayer insulating layer covering the second gate conductive layer, a first source-drain conductive layer above the interlayer insulating layer, a first planarization layer covering the first source-drain conductive layer, a second source-drain conductive layer above the first planarization layer, and a second planarization layer covering the second source-drain conductive layer, wherein the constant voltage bus lines and the constant voltage supply lines are in the first source-drain conductive layer, and wherein the second connection portions are in the second source-drain conductive layer.

The data supply lines may be in one of the first gate conductive layer or the second gate conductive layer, wherein the first connection portions are in another of the first gate conductive layer or the second gate conductive layer.

The data supply lines may be in the first gate conductive layer or the second gate conductive layer, wherein the first connection portions are spaced apart from the data supply lines in the first gate conductive layer or the second gate conductive layer.

The preparing of the display panel may further include arranging data supply lines configured to transmit data signals in the non-display area, extending from the pad area to the display area, and electrically connected to others of the pads.

The display panel may include a first semiconductor layer above the substrate, a first gate-insulating layer covering the first semiconductor layer, a first gate conductive layer above the first gate-insulating layer, a second gate-insulating layer covering the first gate conductive layer, a second gate conductive layer above the second gate-insulating layer, an additional interlayer insulating layer covering the second gate conductive layer, a second semiconductor layer above the additional interlayer insulating layer, a third gate-insulating layer covering the second semiconductor layer, a third gate conductive layer above the third gate-insulating layer, an interlayer insulating layer covering the third gate conductive layer, a first source-drain conductive layer above the interlayer insulating layer, a first planarization layer covering the first source-drain conductive layer, a second source-drain conductive layer above the first planarization layer, and a second planarization layer covering the second source-drain conductive layer, wherein the constant voltage bus lines and the constant voltage supply lines are in the first source-drain conductive layer, wherein the second connection portions are in the second source-drain conductive layer, wherein the data supply lines are in the first gate conductive layer or the second gate conductive layer, and wherein the first connection portions are in the third gate conductive layer.

According to an aspect of the present disclosure, there is provided an electronic device including a display device for displaying an image, a memory for storing an application, a processor for executing the application, and configured to transmit an image data signal and an input control signal to the display device, and a power module configured to transmit power to the display device, wherein the display device includes a circuit board, and a display panel including a substrate including a display area, and a non-display area around the display area, pads in a pad area of the non-display area adjacent to an edge of the substrate, and electrically connected to the circuit board, a circuit layer above the substrate, and including light-emitting pixel drivers, data lines in the display area and configured to transmit a data signal, constant voltage supply lines in the pad area, configured to transmit a constant voltage, and electrically connected to some of the pads, data supply lines in the non-display area, and respectively electrically connected between others of the pads and the data lines, constant voltage bus lines in the non-display area between the pad area and the display area, and extending along an edge of the display area, and constant voltage connection lines respectively electrically connected between the constant voltage supply lines and the constant voltage bus lines, and including a first connection portion below the constant voltage bus lines, and a second connection portion above the constant voltage bus lines, and an element layer above the circuit layer and including light-emitting elements respectively electrically connected to the light-emitting pixel drivers.

The circuit layer may include a first semiconductor layer above the substrate, a first gate-insulating layer covering the first semiconductor layer, a first gate conductive layer above the first gate-insulating layer, a second gate-insulating layer covering the first gate conductive layer, a second gate conductive layer above the second gate-insulating layer, an interlayer insulating layer covering the second gate conductive layer, a first source-drain conductive layer above the interlayer insulating layer, a first planarization layer covering the first source-drain conductive layer, a second source-drain conductive layer above the first planarization layer, and a second planarization layer covering the second source-drain conductive layer, wherein the constant voltage bus lines and the constant voltage supply lines are in the first source-drain conductive layer, and wherein the second connection portion is in the second source-drain conductive layer.

The data supply lines may be in one of the first gate conductive layer or the second gate conductive layer, wherein the first connection portion is in another of the first gate conductive layer or the second gate conductive layer.

The data supply lines may be in the first gate conductive layer or the second gate conductive layer, wherein the first connection portion is spaced apart from the data supply lines and in the first gate conductive layer or the second gate conductive layer.

The circuit layer may include a first semiconductor layer above the substrate, a first gate-insulating layer covering the first semiconductor layer, a first gate conductive layer above the first gate-insulating layer, a second gate-insulating layer covering the first gate conductive layer, a second gate conductive layer above the second gate-insulating layer, an additional interlayer insulating layer covering the second gate conductive layer, a second semiconductor layer above the additional interlayer insulating layer, a third gate-insulating layer covering the second semiconductor layer, a third gate conductive layer above the third gate-insulating layer, an interlayer insulating layer covering the third gate conductive layer, a first source-drain conductive layer above the interlayer insulating layer, a first planarization layer covering the first source-drain conductive layer, a second source-drain conductive layer above the first planarization layer, and a second planarization layer covering the second source-drain conductive layer, wherein the constant voltage bus lines and the constant voltage supply lines are in the first source-drain conductive layer, wherein the second connection portion is in the second source-drain conductive layer, wherein the data supply lines are in the first gate conductive layer or the second gate conductive layer, and wherein the first connection portion is in the third gate conductive layer.

According to one or more embodiments, the constant voltage connection lines may comprise a first connection portion located below the constant voltage bus lines, and a second connection portion located above the constant voltage bus lines.

In this way, during the placement process of the constant voltage bus lines, the constant voltage bus lines may be respectively electrically connected to constant voltage pad lines through first connection portions of the constant voltage connection lines, so that none of the constant voltage bus lines may be in a floating state.

Therefore, even if static electricity is introduced into the constant voltage bus lines, the static electricity may not be concentrated to some of the constant voltage bus lines, but may be suitably dispersed to the first connection portions of the constant voltage connection lines and the constant voltage pad lines, thereby reducing or preventing the likelihood of damage or breakage of the constant voltage bus lines that might be caused by the static electricity.

Therefore, the quality reliability and yield of the display device and the electronic device including the same may be improved.

It should be noted that aspects of the present disclosure are not limited to those described above and other aspects of the present disclosure will be apparent to those skilled in the art from the following descriptions.

### BRIEF DESCRIPTION OF THE DRAWINGS

The above and other aspects of the present disclosure will become more apparent by describing in detail embodiments thereof with reference to the attached drawings, in which:
FIG. 1 is a perspective view illustrating a display device according to one or more embodiments;
FIG. 2 is a cross-sectional view taken along the line A-A' of FIG. 1;
FIG. 3 is a plan view illustrating a circuit board and a circuit layer of a display panel in a display device according to one or more embodiments;
FIG. 4 is a plan view showing a circuit layer and pads in a display panel of a display device according to one or more embodiments;
FIG. 5 is a block diagram illustrating the display device of FIG. 3 according to one or more embodiments;
FIG. 6 is an equivalent circuit diagram showing the light-emitting pixel driver of FIG. 5 according to one or more embodiments;
FIG. 7 is a cross-sectional view showing a first transistor, a sixth transistor, and a light-emitting element of FIG. 6 according to one or more embodiments;
FIG. 8 is a schematic diagram showing part B of FIG. 4 according to one or more embodiments;
FIG. 9 is a cross-sectional view taken along the line C-C' of FIG. 8 according to one or more embodiments;
FIG. 10 is a cross-sectional view taken along the line D-D' of FIG. 8 according to one or more embodiments;
FIG. 11 is a cross-sectional view taken along the line E-E' of FIG. 8 according to one or more embodiments;
FIG. 12 is a cross-sectional view taken along the line C-C' of FIG. 8 according to one or more embodiments;
FIG. 13 is a cross-sectional view taken along the line D-D' of FIG. 8 according to one or more embodiments;
FIG. 14 is a cross-sectional view taken along the line D-D' of FIG. 8 according to one or more embodiments;
FIG. 15 is a cross-sectional view taken along the line E-E' of FIG. 8 according to one or more embodiments;
FIG. 16 is an equivalent circuit diagram showing the light-emitting pixel driver of FIG. 5 according to one or more embodiments;
FIG. 17 is a cross-sectional view showing the first transistor, the second transistor, the fourth transistor, the sixth transistor, and the light-emitting element of FIG. 16 according to one or more embodiments;
FIG. 18 is a cross-sectional view taken along the line C-C' of FIG. 8 according to one or more embodiments;
FIG. 19 is a cross-sectional view taken along the line D-D' of FIG. 8 according to one or more embodiments;
FIG. 20 is a cross-sectional view taken along the line E-E' of FIG. 8 according to one or more embodiments;
FIG. 21 is a flowchart illustrating a method for manufacturing the display device according to one or more embodiments;
FIGS. 22, 23, 24, 25, and 26 are process diagrams illustrating some of the operations of FIG. 21;
FIG. 27 is a block diagram of an electronic device according to one or more embodiments; and
FIG. 28 is schematic views of electronic devices according to various embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Hereinafter, embodiments will be described with reference to the accompanying drawings.

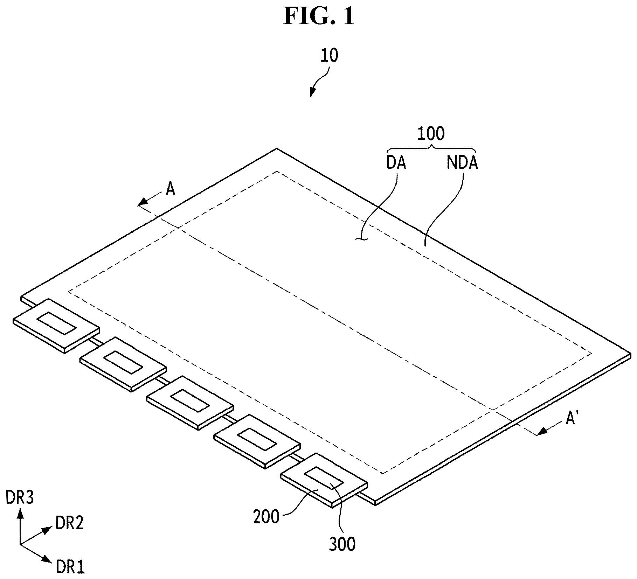

FIG. 1 is a perspective view illustrating a display device according to one or more embodiments.

Referring to FIG. 1, a display device 10 according to one or more embodiments is a device for displaying a moving image or a still image. The display device 10 may be used as a display screen of various devices, such as a television, a laptop computer, a monitor, a billboard, and an Internet-of-Things (IOT) device, as well as portable electronic devices, such as a mobile phone, a smartphone, a tablet personal computer (PC), a smart watch, a watch phone, a mobile communication terminal, an electronic notebook, an electronic book, a portable multimedia player (PMP), a navigation device, and an ultra-mobile PC (UMPC).

The display device 10 may be a light-emitting display device, such as an organic light-emitting display using an organic light-emitting diode, a quantum dot light-emitting display including a quantum dot light-emitting layer, an inorganic light-emitting display including an inorganic semiconductor, and a micro light-emitting display using a micro or nano light-emitting diode (LED). In the following description, it is assumed that the display device 10 is an organic light-emitting display device. However, the present disclosure is not limited thereto, and may be applied to a display device including an organic insulating material, an organic light-emitting material, and a metal material.

According to one or more embodiments, the display device 10 may be an organic light-emitting display device.

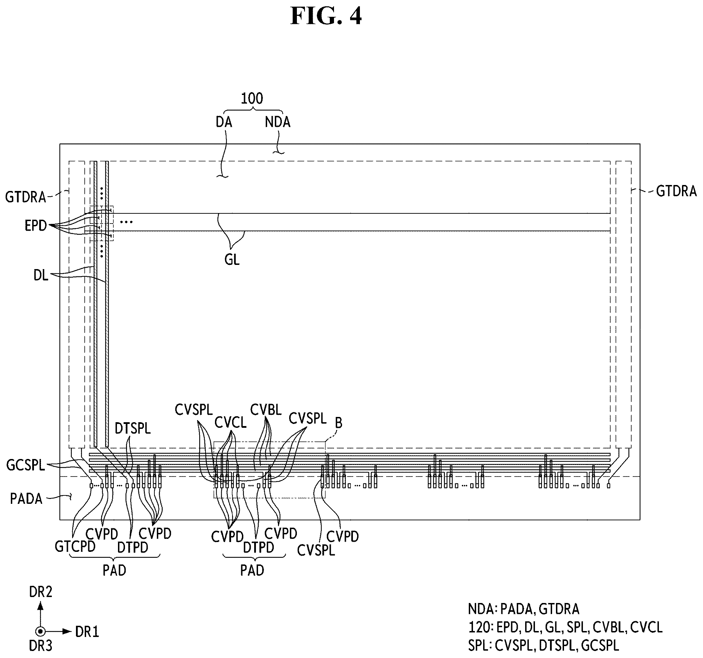

As shown in FIG. 1, according to one or more embodiments, the display device 10 may include a display panel 100 that displays an image, and at least one circuit board 200 electrically connected to pads PAD (see FIG. 4) of the display panel 100.

The display panel 100 may include a rectangular surface. However, this is nothing more than an example, and the shape of the display panel 100 is not limited to the illustration shown in FIG. 1. That is, the display panel 100 according to one or more embodiments may include a surface in a polygonal shape, a circular shape, or an elliptical shape, in addition to the rectangular shape. Alternatively, at least a part of the display panel 100 may be unfolded, and transformed to be bent, curved, folded, or rolled.

The display panel 100 may be formed to be flat, but is not limited thereto. For example, the display panel 100 may include a curved portion formed at left and right ends and having a constant curvature or a varying curvature.

One surface of the display panel 100 may include a display area DA that emits light for displaying an image, and a non-display area NDA located around the display area DA.

The display area DA may be located in most of one surface of the display device 10.

The non-display area NDA may not emit light for displaying an image, and may have a frame shape that surrounds the periphery of the display area DA (e.g., surrounds in a plan view). For example, the non-display area NDA may be maintained in a corresponding color, such as black or the like.

The display panel 100 may include the pads PAD (see FIG. 4) arranged in a pad area PADA (see FIG. 4) of the non-display area NDA.

The pads PAD (see FIG. 4) may be arranged along one edge of the display panel 100. For example, the pads PAD (see FIG. 4) may be arranged along the lower edge of the display panel 100.

The at least one circuit board 200 may be attached to one edge of the display panel 100 and electrically connected to the pads (PAD in FIG. 4).

The at least one circuit board 200 may be a flexible printed circuit board, a printed circuit board, or a flexible film, such as a chip on film.

The at least one circuit board 200 may be adhered to the pads PAD (see FIG. 4), using a low-resistance, high-reliability material, such as an anisotropic conductive film or self-assembly anisotropic conductive paste (SAP). As a result, the at least one circuit board 200 may be electrically connected to the pads PAD (see FIG. 4) and the lines connected thereto.

According to one or more embodiments, the display device 10 may further include a display-driving circuit chip 300 mounted on the at least one circuit board 200.

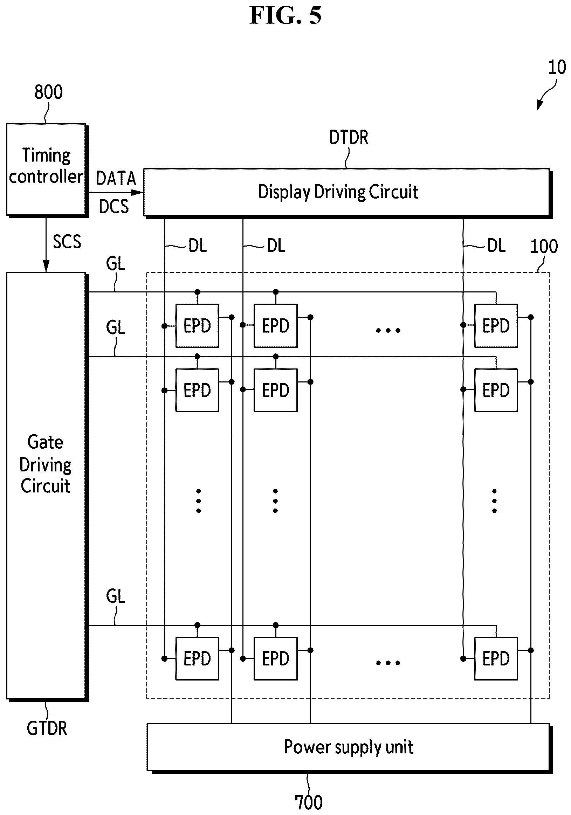

The display-driving circuit chip 300 may incorporate a data driver DTDR (see FIG. 5) that supplies data signals Vdata, and may be formed as an integrated circuit (IC).

Alternatively, the mounting position of the display-driving circuit chip 300 according to one or more embodiments is not limited to the illustration shown in FIG. 1. That is, according to one or more embodiments, the display-driving circuit chip 300 may be mounted on the display panel 100 by a chip-on-glass (COG) method, a chip-on-plastic (COP) method, or an ultrasonic bonding method.

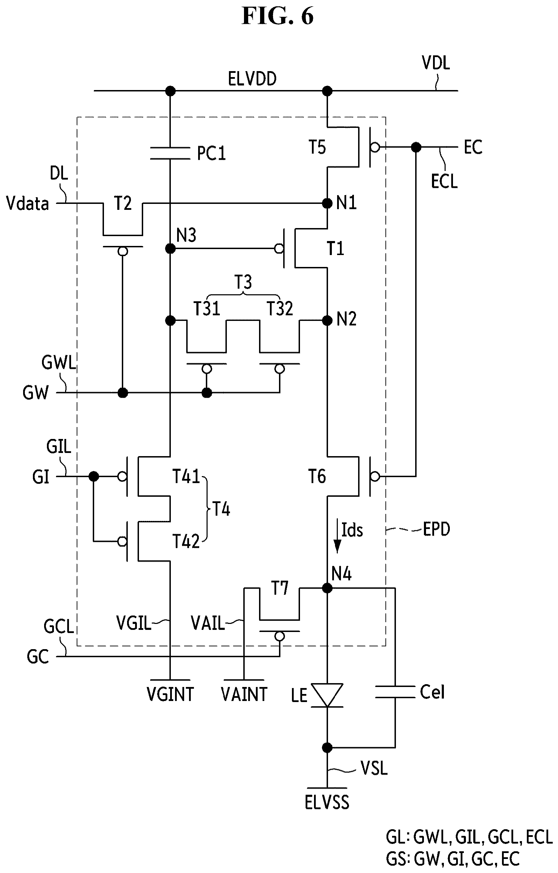

The display panel 100 may receive the data signals Vdata (see FIG. 6), various electric powers, and various voltages through the at least one circuit board 200.

According to one or more embodiments, the display panel 100 may incorporate a gate driver GTDR (see FIG. 5) that supplies gate signals GS (see FIG. 6). In this case, the display panel 100 may receive a scan control signal SCS (see FIG. 5) for controlling the operation timing of the gate driver GTDR (see FIG. 5) through the at least one circuit board 200.

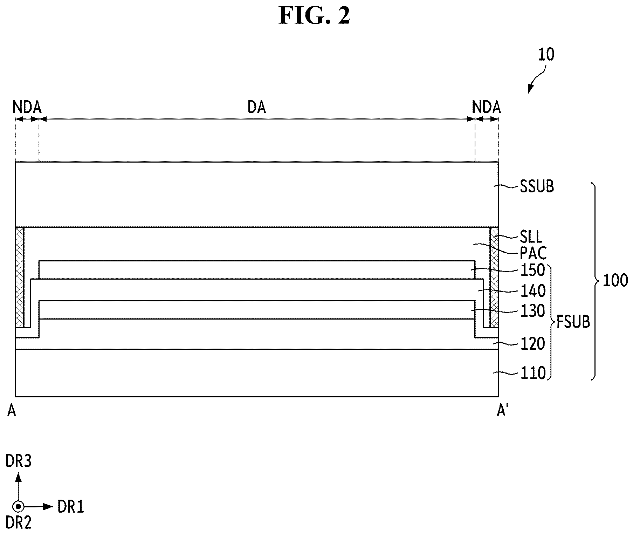

FIG. 2 is a cross-sectional view taken along the line A-A' of FIG. 1.

As illustrated in FIG. 2, according to one or more embodiments, the display panel 100 may include a substrate 110 including the display area DA and the non-display area NDA, and a circuit layer 120 located on the substrate 110 (as used herein, "located on" may mean "above").

According to one or more embodiments, the display panel 100 may include a first substrate FSUB, a second substrate SSUB, and a filling layer PAC filled between the first substrate FSUB and the second substrate SSUB.

The display panel 100 may further include a sealing layer SLL located in the non-display area NDA between the first substrate FSUB and the second substrate SSUB.

The first substrate FSUB and the second substrate SSUB may be bonded to each other by the sealing layer SLL.

The filling layer PAC may fill the space surrounded by the first FSUB, the second substrate SSUB, and the sealing layer SLL, and may contain a transparent organic material.

Each of the first substrate FSUB and the second substrate SSUB may include the display area DA and the non-display area NDA.

The first substrate FSUB may include the substrate 110 having the display area DA and the non-display area NDA, and the circuit layer 120 located on the substrate 110.

The first substrate FSUB may further include an element layer 130 located on the circuit layer 120, an encapsulation layer 140 covering the element layer 130, and a touch sensor layer 150 located on the encapsulation layer 140.

The second substrate SSUB may contain a transparent material.

Each of the first substrate FSUB and the second substrate SSUB may have sufficient strength to maintain its shape without being damaged under the pressure of the bonding process.

For example, each of the substrate 110 of the first substrate FSUB and the second substrate SSUB may include at least one material of glass, a polymer material, or plastic.

At least one of the first substrate FSUB or the second substrate SSUB may include a polarization layer to reduce reflection of external light.

The circuit layer 120 may include at least one semiconductor layer, two or more conductive layers, and insulating layers respectively covering them.

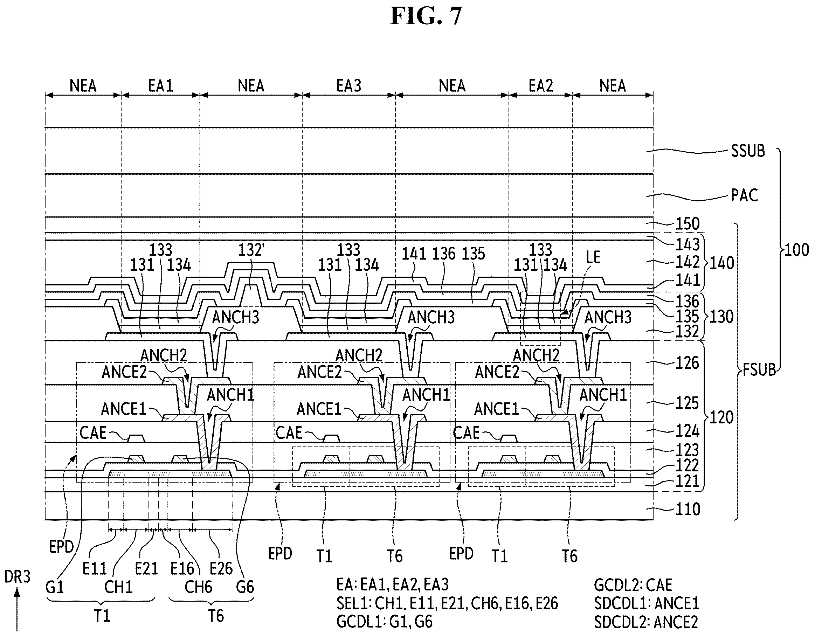

The element layer 130 may include light-emitting elements LE (see FIGS. 6 and 7) located in emission areas EA.

The encapsulation layer 140 may cover the element layer 130. The encapsulation layer 140 may have a structure including two or more inorganic insulating layers and at least one organic layer interposed between them.

Because the organic light-emitting material of the light-emitting elements LE in the element layer 130 can be sealed by the encapsulation layer 140, degradation of the light-emitting elements LE due to oxygen or moisture may be delayed, reduced, or prevented.

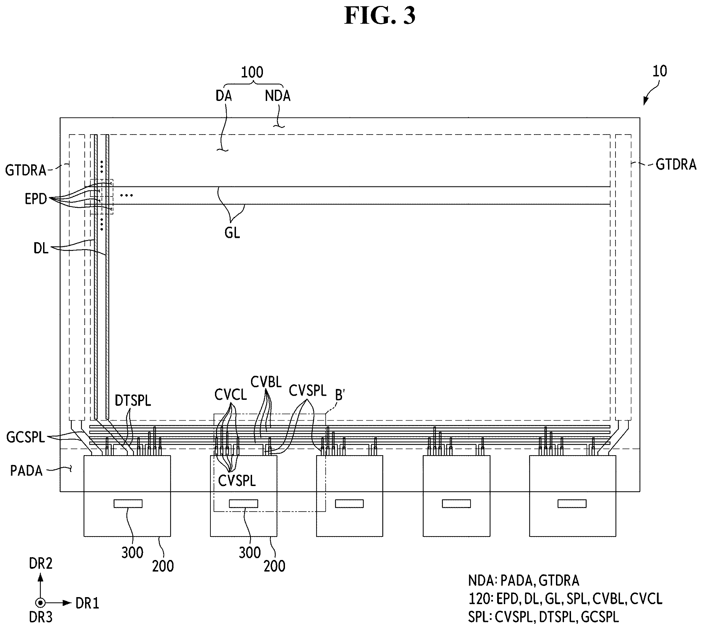

FIG. 3 is a plan view illustrating a circuit board and a circuit layer of a display panel in a display device according to one or more embodiments. FIG. 4 is a plan view showing a circuit layer and pads in a display panel of a display device according to one or more embodiments.

As illustrated in FIG. 2, according to one or more embodiments, the display panel 100 may include the substrate 110 including the display area DA and the non-display area NDA, and the circuit layer 120 located on the substrate 110.

As shown in FIGS. 3 and 4, the non-display area NDA may include the pad area PADA that is adjacent to the edge of the substrate 110 (see FIG. 2).

The pad area PADA may be in contact with at least a portion of the edge of the substrate 110 (see FIG. 2). For example, the pad area PADA may be a portion of the non-display area NDA that is in contact with one edge (lower edge in FIGS. 3 and 4) of the substrate 110 (see FIG. 2) in a second direction DR2. As shown in FIG. 4, according to one or more embodiments, the display panel 100 may include the pads PAD located in the pad area PADA.

As shown in FIGS. 3 and 4, according to one or more embodiments, the circuit layer 120 of the display panel 100 may include light-emitting pixel drivers EPD arranged in the display area DA in a first direction DR1 and the second direction DR2, and data lines DL located in the display area DA and extending in the second direction DR2.

The light-emitting pixel drivers EPD may be respectively electrically connected to the light-emitting elements LE (see FIGS. 6 and 7) of the element layer 130 (see FIG. 2).

The data lines DL may transmit the data signals Vdata (see FIG. 6) to the light-emitting pixel drivers EPD.

The circuit layer 120 may further include gate lines GL located in the display area DA and extending in the first direction DR1.

The gate lines GL may transmit the gate signals GS (see FIG. 6) to the light-emitting pixel drivers EPD.

According to one or more embodiments, the circuit layer 120 of the display panel 100 may include data supply lines DTSPL located in the non-display area NDA and respectively electrically connected to the data lines DL.

As shown in FIG. 4, the pads PAD may include data supply pads DTPD for transmitting the data signals Vdata (see FIG. 6).

The data supply lines DTSPL may be respectively electrically connected to the data supply pads DTPD among the pads PAD. In other words, the data supply lines DTSPL may be respectively electrically connected between the data pads DTPD and the data lines DL.

The non-display area NDA may include at least one gate-driving circuit area GTDRA facing at least one side of the display area DA. As an example, the at least one gate-driving circuit area GTDRA may face one side or two opposite sides of the display area DA in the first direction DR1.

According to one or more embodiments, the circuit layer 120 of the display panel 100 may include the gate driver GTDR (see FIG. 5) located in the at least one gate-driving circuit area GTDRA for supplying the gate signals GS (see FIG. 6), and gate control supply lines GCSPL extending from the pad area PADA to the at least one gate-driving circuit area GTDRA.

The pads PAD may include gate control pads GTCPD for transmitting the scan control signals SCS (see FIG. 5) for controlling the driving timing of the gate driver GTDR (see FIG. 5).

The gate control supply lines GCSPL may be electrically connected to the gate control pads GTCPD, and may extend to the at least one gate-driving circuit area GTDRA.

As shown in FIGS. 3 and 4, according to one or more embodiments, the circuit layer 120 of the display panel 100 may include constant voltage supply lines CVSPL located in the pad area PADA for transmitting a constant voltage, constant voltage bus lines CVBL located in a partial area of the non-display area NDA between the pad area PADA and the display area DA and extending along a part of the edge of the display area DA, and constant voltage connection lines CVCL respectively electrically connected between the constant voltage supply lines CVSPL and the constant voltage bus lines CVBL. The constant voltage may refer to a voltage having a level that does not vary.

According to one or more embodiments, the constant voltage transmitted to the display panel 100 may include a first power ELVDD (see FIG. 6) and a second power ELVSS (see FIG. 6) for generating a driving current Ids (see FIG. 6) of the light-emitting elements LE (see FIGS. 6 and 7), a gate initialization voltage VGINT for initializing the potential of the gate electrode of a first transistor T1 (see FIG. 6), and an anode initialization voltage VAINT for initializing the potential of a fourth node N4 (see FIG. 6) of the light-emitting pixel driver EPD electrically connected to the light-emitting element LE (see FIGS. 6 and 7).

According to one or more embodiments, the constant voltage transmitted to the display panel 100 may further include a reference voltage for initializing the potential of a selected node.

According to one or more embodiments, the light-emitting elements LE (see FIGS. 6 and 7) of the element layer 130 (see FIG. 2) may include a first light-emitting element located in a first emission area EA1 (see FIG. 7) for emitting light of a first wavelength band, a second light-emitting element located in a second emission area EA2 (see FIG. 7) for emitting light of a second wavelength band that is lower than the first wavelength band, and a third light-emitting element located in a third emission area EA3 (see FIG. 7) for emitting light of a third wavelength band that is lower than the second wavelength band.

For example, the first wavelength band may be about 600 nm to about 750 nm, and the light of the first wavelength band may be red. The second wavelength band may be about 480 nm to about 560 nm, and light of the second wavelength band may be green. The third wavelength band may be about 370 nm to about 460 nm, and light of the third wavelength band may be blue.

The light-emitting layer of the first light-emitting element, the light-emitting layer of the second light-emitting element, and the light-emitting layer of the third light-emitting element may include different respective organic materials.

Accordingly, because the first light-emitting element, the second light-emitting element, and the third light-emitting element include different respective parasitic capacitances, the initialization of the first light-emitting element, the second light-emitting element, and the third light-emitting element may be suitably performed with the initialization voltage VAINT (see FIG. 6) of different voltage levels.

Therefore, according to one or more embodiments, the constant voltage transmitted to the display panel 100 may include three anode initialization voltages VAINT (see FIG. 6) having different respective voltage levels.

According to one or more embodiments, the circuit layer 120 may include the light-emitting pixel drivers EPD, the gate lines GL, and the data lines DL located in the display area DA, and also may include supply lines SPL, the constant voltage bus lines CVBL, the constant voltage connection lines CVCL, and the pads PAD located in the non-display area NDA.

The pads PAD may include the data supply pads DTPD for transmitting the data signals Vdata (see FIG. 6), the gate control pads GTCPD for transmitting the scan control signals SCS (see FIG. 5), and constant voltage supply pads CVPD for transmitting constant voltages.

The supply lines SPL may be electrically connected to the pads PAD, respectively. The supply lines SPL may include the data supply lines DTSPL respectively electrically connected to the data supply pads DTPD, the gate control supply lines GCSPL respectively electrically connected to the gate control pads GTCPD, and the constant voltage supply lines CVSPL respectively electrically connected to the constant voltage supply pads CVPD.

The data supply lines DTSPL may extend from the pad area PADA to the display area DA, and may be respectively electrically connected to the data lines DL.

The gate control supply lines GCSPL may extend from the pad area PADA to at least one gate-driving circuit area GTDRA, and may be electrically connected to the gate driver GTDR (see FIG. 5).

The constant voltage bus lines CVBL may be respectively electrically connected to the constant voltage supply lines CVSPL through the constant voltage connection lines CVCL.

FIG. 5 is a block diagram illustrating the display device of FIG. 3 according to one or more embodiments.

As shown in FIG. 5, according to one or more embodiments, the display device 10 may include the display panel 100, the data driver DTDR for supplying the data signals Vdata (see FIG. 6) to the display panel 100, the gate driver GTDR supplying the gate signals GS (see FIG. 6) to the display panel 100, a power supply unit 700 for supplying powers and voltages to the display panel 100, and a timing controller 800 for controlling the driving timing of each of the data driver DTDR and the gate driver GTDR.

The display panel 100 may include the light-emitting pixel drivers EPD respectively electrically connected to the light-emitting elements LE (see FIGS. 6 and 7) of the element layer 130 (see FIG. 2), to the gate lines GL for transmitting the gate signals GS (see FIG. 6) to the light-emitting pixel drivers EPD, and to the data lines DL for transmitting the data signals Vdata (see FIG. 6) to the light-emitting pixel drivers EPD.

Each of the gate signals GS (see FIG. 6) is for controlling the turn-on/turn-off operation of at least one of two or more transistors provided in each of the light-emitting pixel drivers EPD.

The data signals Vdata are for controlling the luminance of the light-emitting elements LE.

The timing controller 800 receives an image signal supplied from the outside of the display device 10. The timing controller 800 may output image data DATA and a data control signal DCS to the data driver DTDR.

The data driver DTDR may convert the image data DATA into analog data voltages in response to the data control signal DCS, and may output the data signals Vdata to the data lines DL. The data driver DTDR may be embedded in the display-driving circuit chip 300 (see FIGS. 1 and 3) formed as the integrated circuit IC.

The timing controller 800 may generate the scan control signal SCS for controlling the operation timing of the gate driver GTDR. The gate driver GTDR may generate the gate signals GS (see FIG. 6) in response to the scan control signal SCS, and may output the gate signals GS (see FIG. 6) to the gate lines GL. The gate signals GS (see FIG. 6) may have pulses that vary to a first gate level voltage or a second gate level voltage.

The power supply unit 700 may supply various power and voltages suitable for driving the light-emitting pixel drivers EPD.

FIG. 6 is an equivalent circuit diagram showing the light-emitting pixel driver of FIG. 5 according to one or more embodiments.

As shown in FIG. 6, according to one or more embodiments, the light-emitting pixel driver EPD may be electrically connected between a first power line VDL for transmitting the first power ELVDD and the light-emitting element LE, and the light-emitting element LE may be electrically connected between a second power line VSL for transmitting the second power ELVSS and the light-emitting pixel driver EPD.

The first power ELVDD may be at a voltage level that is higher than that of the second power ELVSS. That is, a first electrode (e.g., an anode electrode) of the light-emitting element LE may be electrically connected to the light-emitting pixel driver EPD, and a second electrode (e.g., a cathode electrode) of the light-emitting element LE may be electrically connected to the second power line VSL.

A capacitor Cel connected in parallel with the light-emitting element LE refers to a parasitic capacitance between the first electrode and the second electrode.

According to one or more embodiments, the light-emitting pixel driver EPD may include a first transistor T1 configured to generate the driving current Ids for driving the light-emitting element LE, two or more transistors T2 to T7 electrically connected to the first transistor T1 or the light-emitting element LE, and a first capacitor PC1.

The light-emitting pixel driver EPD may be electrically connected to the gate lines GL for transmitting the gate signals and the data line DL for transmitting the data signal Vdata.

The gate signals may include a scan write signal GW for the turn-on/turn-off operations of the second transistor T2 and the third transistor T3, a scan initialization signal GI for the turn-on/turn-off operation of the fourth transistor T4, an emission control signal EC for the turn-on/turn-off operations of the fifth transistor T5 and the sixth transistor T6, and a gate control signal GC for the turn-on/turn-off operation of the seventh transistor T7.

That is, the gate lines GL may include a scan write line GWL for transmitting the scan write signal GW, a scan initialization line GIL for transmitting the scan initialization signal GI, an emission control line ECL for transmitting the emission control signal EC, and a gate control line GCL for transmitting the gate control signal GC.

The light-emitting pixel driver EPD may be electrically connected to a gate initialization voltage line VGIL for transmitting the gate initialization voltage VGINT for initializing the potential of the gate electrode of the first transistor T1, and an anode initialization voltage line VAIL for transmitting the anode initialization voltage VAINT for initializing the potential of the first electrode of the light-emitting element LE.

The first transistor T1 may be electrically connected between a first node N1 and a second node N2. The first node N1 may be electrically connected to the first electrode (e.g., source electrode) of the first transistor T1. The second node N2 may be electrically connected to the second electrode (e.g., drain electrode) of the first transistor T1. The gate electrode of the first transistor T1 may be electrically connected to a third node N3.

The second transistor T2 may be electrically connected between the data line DL and the first node N1. The gate electrode of the second transistor T2 may be electrically connected to the scan write line GWL, and the second transistor T2 may be turned on by the scan write signal GW.

The first capacitor PC1 may be electrically connected between the third node N3 and the first power line VDL. The potential of the gate electrode of the first transistor T1 may correspond to the voltage charged in the first capacitor PC1.

When the second transistor T2 is turned on, the data signal Vdata of the data line DL is transmitted to the first electrode of the first transistor T1, so that the voltage difference between the gate electrode of the first transistor T1 and the first electrode of the first transistor T1 may be a difference voltage between the first power ELVDD and the data signal Vdata.

In this case, when the voltage difference between the gate electrode of the first transistor T1 and the first electrode of the first transistor T1 (e.g., the gate-source voltage difference) becomes equal to or greater than a threshold voltage, the first transistor T1 is turned on, so that a drain-source current Ids of the first transistor T1 corresponding to the data signal Vdata may be generated.

The fifth transistor T5 may be electrically connected between the first node N1 and the first power line VDL.

The sixth transistor T6 may be electrically connected between the second node N2 and the fourth node N4.

The fourth node N4 may be electrically connected to the first electrode of the light-emitting element LE.

The gate electrode of the fifth transistor T5 and the gate electrode of the sixth transistor T6 may be electrically connected to the emission control line ECL, and the fifth transistor T5 and the sixth transistor T6 may be turned on by the emission control signal EC.

When the fifth transistor T5 and the sixth transistor T6 are turned on, the first transistor T1 and the light-emitting element LE may be connected in series between the first power ELVDD and the second power ELVSS. Accordingly, the drain-source current Ids of the first transistor T1 corresponding to the data signal Vdata may be transmitted as a driving current of the light-emitting element LE.

Accordingly, the light-emitting element LE may emit light having a luminance corresponding to the data signal Vdata.

The third transistor T3 may be electrically connected between the second node N2 and the third node N3. That is, the third transistor T3 may be electrically connected between the gate electrode of the first transistor T1 and the second electrode of the first transistor T1.

The third transistor T3 may include a plurality of sub-transistors connected in series. For example, the third transistor T3 may include a first sub-transistor T31 and a second sub-transistor T32. The first electrode of the first sub-transistor T31 may be connected to the gate electrode of the first transistor T1, the second electrode of the first sub-transistor T31 may be connected to the first electrode of the second sub-transistor T32, and the second electrode of the second sub-transistor T32 may be connected to the second electrode of the first transistor T1. In this way, it is possible to reduce or prevent change of the potential of the gate electrode of the first transistor T1 due to the leakage current caused by the third transistor T3 that is not turned on.

The gate electrode of the first sub-transistor T31 and the gate electrode of the second sub-transistor T32 may be electrically connected to the scan write line GWL, and the first sub-transistor T31 and the second sub-transistor T32 may be turned on by the scan write signal GW. When the first sub-transistor T31 and the second sub-transistor T32 are turned on, the voltage difference between the second node N2 and the third node N3 may be initialized.

The fourth transistor T4 may be electrically connected between the third node N3 and the gate initialization voltage line VGIL. That is, the fourth transistor T4 may be connected between the gate electrode of the first transistor T1 and the gate initialization voltage line VGIL.

The fourth transistor T4 may include a plurality of sub-transistors connected in series. For example, the fourth transistor T4 may include a third sub-transistor T41 and a fourth sub-transistor T42. The first electrode of the third sub-transistor T41 may be connected to the gate electrode of the first transistor T1, the second electrode of the third sub-transistor T41 may be connected to the first electrode of the fourth sub-transistor T42, and the second electrode of the fourth sub-transistor T42 may be connected to the gate initialization voltage line VGIL. In this way, it is possible to reduce or prevent change of the potential of the gate electrode of the first transistor T1 due to the leakage current caused by the fourth transistor T4 that is not turned on.

The gate electrode of the third sub-transistor T41 and the gate electrode of the fourth sub-transistor T42 may be electrically connected to the scan initialization line GIL, and the third sub-transistor T41 and the fourth sub-transistor T42 may be turned on by the scan initialization signal GI. When the third sub-transistor T41 and the fourth sub-transistor T42 are turned on, the potential of the third node N3 may be initialized to the gate initialization voltage VGINT.

The seventh transistor T7 may be electrically connected between the fourth node N4 and the anode initialization voltage line VAIL. The gate electrode of the seventh transistor T7 may be electrically connected to the gate control line GCL, and the seventh transistor T7 may be turned on by the gate control signal GC. When the seventh transistor T7 is turned on, the potential of the fourth node N4 and the first electrode of the light-emitting element LE electrically connected to the fourth node N4 may be initialized to the anode initialization voltage VAINT.

According to one or more embodiments, the first to seventh transistors T1 to T7 may be formed as P-type MOSFETs. According to one or more other embodiments, the first to seventh transistors T1 to T7 may be formed as N-type MOSFETs. According to one or more other embodiments, some of the first to seventh transistors T1 to T7 may be formed as N-type MOSFETs, and the remaining others may be formed as P-type MOSFETs. For example, the third transistor T3 and the fourth transistor T4 may be formed as N-type MOSFETs, and the first transistor T1, the second transistor T2, the fifth transistor T5, the sixth transistor T6, and the seventh transistor T7 may be formed as P-type MOSFETs.

FIG. 7 is a cross-sectional view showing a first transistor, a sixth transistor, and a light-emitting element of FIG. 6 according to one or more embodiments.

As shown in FIG. 7, according to one or more embodiments, the display panel 100 may include the first substrate FSUB and the second substrate SSUB facing each other, and the filling layer PAC filled between the first substrate FSUB and the second substrate SSUB.

The first substrate FSUB may include the substrate 110, the circuit layer 120 located on the substrate 110, the element layer 130 located on the circuit layer 120, the encapsulation layer 140 covering the element layer 130, and the touch sensor layer 150 located on the encapsulation layer 140 (as used herein, "located on" may mean "above").

According to one or more embodiments, the circuit layer 120 may include an interlayer insulating layer 124 located on the substrate 110, a first source-drain conductive layer SDCDL1 located on the interlayer insulating layer 124, a first planarization layer 125 covering the first source-drain conductive layer, a second source-drain conductive layer SDCDL2 located on the first planarization layer 125, and a second planarization layer 126 covering the second source-drain conductive layer SDCDL2.

According to one or more embodiments, the circuit layer 120 may further include a first semiconductor layer SEL1 located on the substrate 110, a first gate-insulating layer 122 covering the first semiconductor layer SEL1, a first gate conductive layer GCDL1 located on the first gate-insulating layer 122, a second gate-insulating layer 123 covering the first gate conductive layer GCDL1, and a second gate conductive layer GCDL2 located on the second gate-insulating layer 123.

The interlayer insulating layer 124 may cover the second gate conductive layer GCDL2.

According to one or more embodiments, the circuit layer 120 may further include the buffer layer 121 covering the substrate 110. In this case, the first semiconductor layer SEL1 may be located on the buffer layer 121.

The channel portions CH1 and CH6, the first electrode portions E11 and E16, and the second electrode portions E21 and E26 of the first and sixth transistors T1 and T6 may be located in the first semiconductor layer SEL1.

The second electrode portion E21 of the first transistor T1 may be connected to the first electrode portion E16 of the sixth transistor T6.

The gate electrodes G1 and G6 of the first transistor T1 and the sixth transistor T6 may each be located in the first gate conductive layer GCDL1.

The gate electrode G1 of the first transistor T1 may overlap the channel portion CH1 of the first transistor T1 in the third direction DR3.

The gate electrode G6 of the sixth transistor T6 may overlap the channel portion CH6 of the sixth transistor T6 in the third direction DR3.

As shown in FIG. 6, because the second transistor T2, the third transistor T3, the fourth transistor T4, the fifth transistor T5, and the seventh transistor T7 of the light-emitting pixel driver EPD are P-type MOSFETs, they may include the same or similar structure as the first transistor T1 and the sixth transistor T6. Accordingly, redundant description will be omitted below.

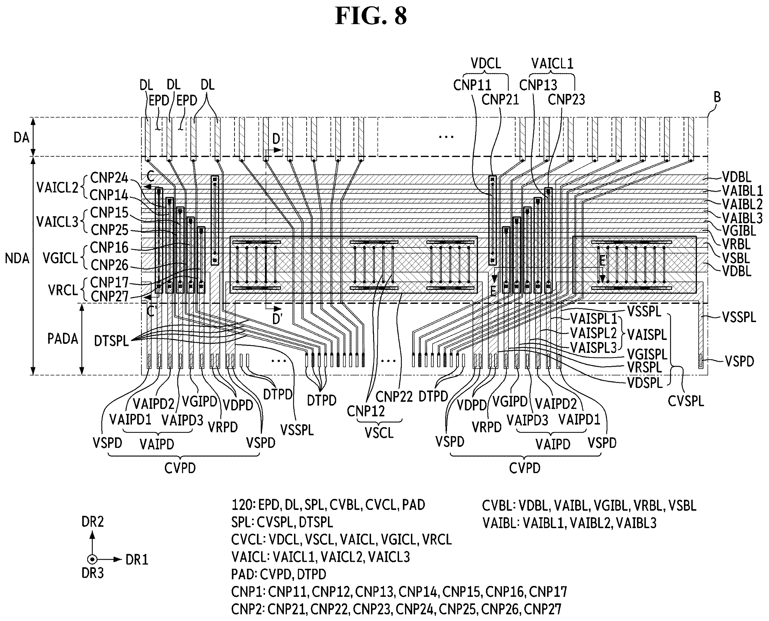

As shown in FIG. 7, the second gate conductive layer GCDL2 may include the capacitor electrode CAE. The capacitor electrode CAE may overlap the gate electrode G1 of the first transistor T1 in the third direction DR3. The capacitor electrode CAE may be electrically connected to the first power line VDL (see FIG. 8). Accordingly, the first capacitor PC1 may be formed by a region where the capacitor electrode CAE and the gate electrode G1 of the first transistor T1 overlap each other in the third direction DR3.

The first source-drain conductive layer SDCDL1 may include the first anode connection electrode ANCE1. The first anode connection electrode ANCE1 may be electrically connected to the second electrode portion E26 of the sixth transistor T6 through a first anode connection hole ANCH1.

The second source-drain conductive layer SDCDL2 may include a second anode connection electrode ANCE2. The second anode connection electrode ANCE2 may be electrically connected to the first anode connection electrode ANCE1 through a second anode connection hole ANCH2.

The element layer 130 may include first electrodes 131 located in the emission areas EA, a pixel-defining layer 132 located in a non-emission area NEA and covering the edges of the first electrodes 131, first common layers 133 located on the first electrodes 131, light-emitting layers 134 located on the first common layers 133, a second common layer 135 located on the pixel-defining layer 132 and the light-emitting layers 134, and a second electrode 136 located on the second common layer 135.

The element layer 130 may further include an auxiliary spacer 132' located on the pixel-defining layer 132, the auxiliary spacers 132' being spaced apart from each other. In this case, the second common layer 135 may be located on the pixel-defining layer 132, the auxiliary spacer 132', and the light-emitting layers 134.

Each of the light-emitting elements LE in the emission areas EA may be formed to have a structure in which the first common layer 133, the light-emitting layer 134, and the second common layer 135 are interposed between the first electrode 131 and the second electrode 136 facing each other.

The first electrode 131 may be located on the second planarization layer 126, and may be electrically connected to the second anode connection electrode ANCE2 through a third anode connection hole ANCH3. Accordingly, the first electrode 131 may be electrically connected to the second electrode portion E26 of the sixth transistor T6 through the first anode connection electrode ANCE1 and the second anode connection electrode ANCE2. Because the first electrodes 131 are respectively located in the emission areas EA and are respectively electrically connected to the light-emitting pixel drivers EPD, they may be referred to as pixel electrodes or anode electrodes.

The second electrode 136 may be located in the entire display area DA including the emission areas EA and the non-emission area NEA, and is shared by the light-emitting elements LE, so it may be referred to as a common electrode or a cathode electrode.

Each of the first common layers 133 may include a hole transport layer. Alternatively, each of the first common layers 133 may further include a hole injection layer.

The second common layer 135 may include an electron transport layer. Alternatively, the second common layer 135 may further include an electron injection layer.

Each of the light-emitting layers 134 may include an organic light-emitting material.

Each of the pixel-defining layer 132 and the auxiliary spacer 132' may include an organic insulating material.

According to one or more embodiments, the encapsulation layer 140 may include a first encapsulation layer 141 located on the element layer 130 and containing an inorganic insulating material, a second encapsulation layer 142 located on the first encapsulation layer 141 and containing an organic insulating material, and a third encapsulation layer 143 covering the second encapsulation layer 142 and containing an inorganic insulating material.

The touch sensor layer 150 may be located on the encapsulation layer 140. The touch sensor layer 150 may include touch electrodes for detecting a signal that varies depending on the touch of a person or an object and sensing a point on the display surface where the touch of the person or the object has occurred.

FIG. 8 is a schematic diagram showing part B of FIG. 4 according to one or more embodiments.

As shown in FIG. 8, the display panel 100 according to one or more embodiments may include the display area DA, the non-display area NDA, and the pads PAD located in the pad area PADA, which is included in the non-display area NDA and adjacent to the edge of the substrate 110 (see FIG. 2).

The display panel 100 may include the circuit layer 120 located on the substrate 110 (see FIG. 2).

According to one or more embodiments, the circuit layer 120 may include the constant voltage supply lines CVSPL located in the pad area PADA to transmit a constant voltage and electrically connected to some of the pads PAD (e.g., constant voltage supply pads CVPD), the constant voltage bus lines CVBL located in a partial area of the non-display area NDA between the pad area PADA and the display area DA and extending along a part of the edge of the display area DA, and the constant voltage connection lines CVCL respectively electrically connected between the constant voltage supply lines CVSPL and the constant voltage bus lines CVBL.

According to one or more embodiments, each of the constant voltage connection lines CVCL may include a first connection portion CNP1 located below (e.g., in a thickness direction) the constant voltage bus lines CVBL, and a second connection portion CNP2 located above (e.g., in the thickness direction) the constant voltage bus lines CVBL.

In this way, during the process of placing the constant voltage bus lines CVBL, because the constant voltage bus lines CVBL are electrically connected to the constant voltage supply lines CVSPL through the first connection portion CNP1, all of the constant voltage bus lines CVBL may be kept from being in a floating state, which is relatively vulnerable to static electricity.

Therefore, even if static electricity is introduced during the process of placing the constant voltage bus lines CVBL, the static electricity may be suitably dispersed through the first connection portion CNP1 and the constant voltage supply lines CVSPL, thereby reducing or preventing the likelihood of breakage or damage of the constant voltage bus lines CVBL due to the concentration of the static electricity.

According to one or more embodiments, the circuit layer 120 may include the light-emitting pixel drivers EPD and the data lines DL located in the display area DA, and also may include the pads PAD, the supply lines SPL, the constant voltage bus lines CVBL, and the constant voltage connection lines CVCL located in the non-display area NDA.

The pads PAD may include the data supply pads DTPD for transmitting the data signals Vdata (see FIG. 6), and the constant voltage supply pads CVPD for transmitting constant voltages.

The supply lines SPL may be electrically connected to the pads PAD. The supply lines SPL may include the data supply lines DTSPL respectively electrically connected to the data supply pads DTPD, and the constant voltage supply lines CVSPL respectively electrically connected to the constant voltage supply pads CVPD.

According to one or more embodiments, the constant voltage supply pads CVPD may include a first power supply pad VDPD for transmitting the first power ELVDD (see FIG. 6), a second power supply pad VSPD for transmitting the second power ELVSS (see FIG. 6), a gate initialization voltage supply pad VGIPD for transmitting the gate initialization voltage VGINT (see FIG. 6), and an anode initialization voltage supply pad VAIPD for transmitting the anode initialization voltage VAINT (see FIG. 6).

The constant voltage supply lines CVSPL may include a first power supply line VDSPL electrically connected to the first power supply pad VDPD, a second power supply line VSSPL electrically connected to the second power supply pad VSPD, a gate initialization voltage supply line VGISPL electrically connected to the gate initialization voltage supply pad VGIPD, and an anode initialization voltage supply line VAISPL electrically connected to the anode initialization voltage supply pad VAIPD.

The constant voltage bus lines CVBL may include a first power bus line VDBL for transmitting the first power ELVDD (see FIG. 6), a second power bus line VSBL for transmitting the second power ELVSS (see FIG. 6), a gate initialization voltage bus line VGIBL for transmitting the gate initialization voltage VGINT (see FIG. 6), and an anode initialization voltage bus line VAIBL for transmitting the anode initialization voltage VAINT (see FIG. 6).

The constant voltage connection lines CVCL may include a first power connection line VDCL electrically connected between the first power supply line VDSPL and the first power bus line VDBL, a second power connection line VSCL electrically connected between the second power supply line VSSPL and the second power bus line VSBL, a gate initialization voltage connection line VGICL electrically connected between the gate initialization voltage supply line VGISPL and the gate initialization voltage bus line VGIBL, and an anode initialization voltage connection line VAICL electrically connected between the anode initialization voltage supply line VAISPL and the anode initialization voltage bus line VAIBL.

According to one or more embodiments, the constant voltage supply pads CVPD may further include a reference voltage supply pad VRPD for transmitting a reference voltage.

In this case, the constant voltage supply lines CVSPL may further include a reference voltage supply line VRSPL electrically connected to the reference voltage supply pad VRPD.

The constant voltage bus lines CVBL may further include a reference voltage bus line VRBL for transmitting a reference voltage.

In addition, the constant voltage connection lines CVCL can further include a reference voltage connection line VRCL electrically connected between the reference voltage supply line VRSPL and the reference voltage bus line VRBL.

According to one or more embodiments, the element layer 130 (see FIG. 2) may include a first light-emitting element located in the first emission area EA1 (see FIG. 7), a second light-emitting element located in the second emission area EA2 (see FIG. 7), and a third light-emitting element located in the third emission area EA3 (see FIG. 7).

In this case, the anode initialization voltage supply pad VAIPD may include a first anode initialization voltage supply pad VAIPD1 transmitting a first anode initialization voltage, a second anode initialization voltage supply pad VAIPD2 transmitting a second anode initialization voltage, and a third anode initialization voltage supply pad VAIPD3 transmitting a third anode initialization voltage.

The first anode initialization voltage, the second anode initialization voltage, and the third anode initialization voltage may have different voltage levels.

Accordingly, the anode initialization voltage supply line VAISPL may include a first anode initialization voltage supply line VAISPL1 electrically connected to the first anode initialization voltage supply pad VAIPD1, a second anode initialization voltage supply line VAISPL2 electrically connected to the second anode initialization voltage supply pad VAIPD2, and a third anode initialization voltage supply line VAISPL3 electrically connected to the third anode initialization voltage supply pad VAIPD3.

The anode initialization voltage bus line VAIBL may include a first anode initialization voltage bus line VAIBL1 transmitting the first anode initialization voltage, a second anode initialization voltage bus line VAIBL2 transmitting the second anode initialization voltage, and a third anode initialization voltage bus line VAIBL3 transmitting the third anode initialization voltage.

In addition, the anode initialization voltage connection line VAICL may include a first anode initialization voltage connection line VAICL1 electrically connected between the first anode initialization voltage supply line VAISPL1 and the first anode initialization voltage bus line VAIBL1, a second anode initialization voltage connection line VAICL2 electrically connected between the second anode initialization voltage supply line VAISPL2 and the second anode initialization voltage bus line VAIBL2, and a third anode initialization voltage connection line VAICL3 electrically connected between the third anode initialization voltage supply line VAISPL3 and the third anode initialization voltage bus line VAIBL3.

According to one or more embodiments, each of the constant voltage connection lines CVCL may include the first connection portion CNP1 and the second connection portion CNP2.

A first connection portion CNP11 and a second connection portion CNP21 of the first power connection line VDCL may be electrically connected between the first power supply line VDSPL and the first power bus line VDBL, and may overlap each other in the third direction DR3.

A first connection portion CNP12 and a second connection portion CNP22 of the second power connection line VSCL may be electrically connected between the second power supply line VSSPL and the second power bus line VSBL, and may overlap each other in the third direction DR3.

A first connection portion CNP13 and a second connection portion CNP23 of the first anode initialization voltage connection line VAICL1 may be electrically connected between the first anode initialization voltage supply line VAISPL1 and the first anode initialization voltage bus line VAIBL1, and may overlap each other in the third direction DR3.

A first connection portion CNP14 and a second connection portion CNP24 of the second anode initialization voltage connection line VAICL2 may be electrically connected between the second anode initialization voltage supply line VAISPL2 and the second anode initialization voltage bus line VAIBL2, and may overlap each other in the third direction DR3.

A first connection portion CNP15 and a second connection portion CNP25 of the third anode initialization voltage connection line VAICL3 may be electrically connected between the third anode initialization voltage supply line VAISPL3 and the third anode initialization voltage bus line VAIBL3, and may overlap each other in the third direction DR3.

A first connection portion CNP16 and a second connection portion CNP26 of the gate initialization voltage connection line VGICL may be electrically connected between the gate initialization voltage supply line VGISPL and the gate initialization voltage bus line VGIBL, and may overlap each other in the third direction DR3.

A first connection portion CNP17 and a second connection portion CNP27 of the reference voltage connection line VRCL may be electrically connected between the reference voltage supply line VRSPL and the reference voltage bus line VRBL, and may overlap each other in the third direction DR3.

According to one or more embodiments, the number and layout of each of the constant voltage supply pads CVPD, the constant voltage supply lines CVSPL, the constant voltage bus lines CVBL, and the constant voltage connection lines CVCL may not be limited to those shown in FIG. 8, and may be modified in various ways according to the number of the constant voltages supplied to the display panel 100.

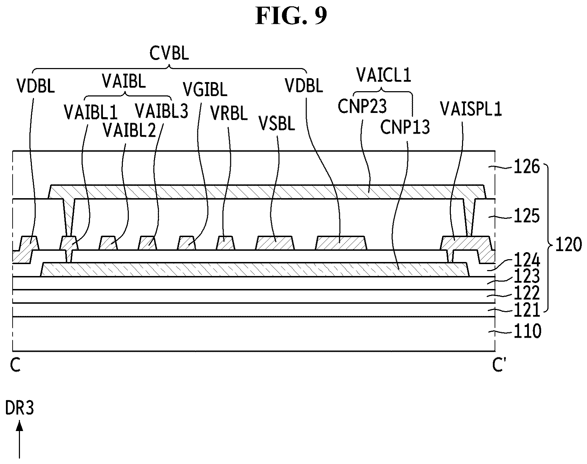

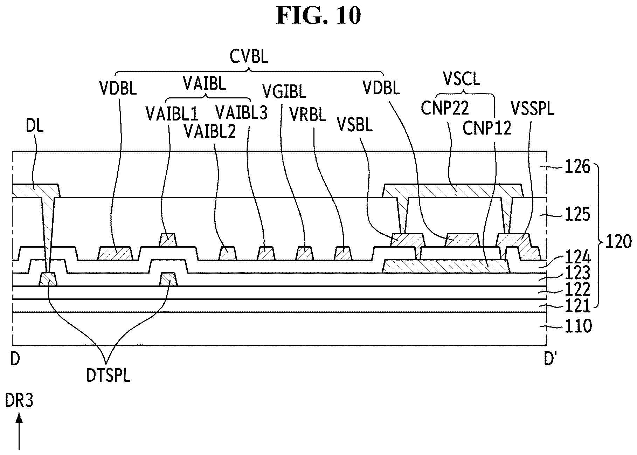

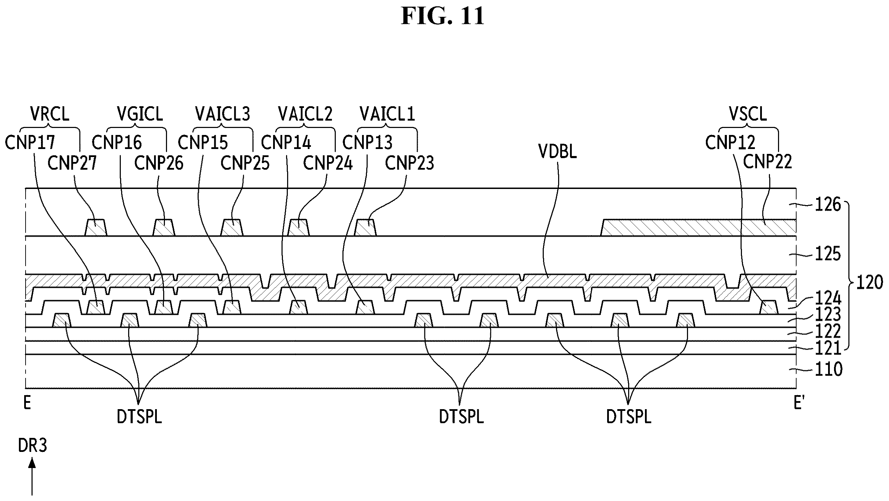

FIG. 9 is a cross-sectional view taken along the line C-C' of FIG. 8 according to one or more embodiments. FIG. 10 is a cross-sectional view taken along the line D-D' of FIG. 8 according to one or more embodiments. FIG. 11 is a cross-sectional view taken along the line E-E' of FIG. 8 according to one or more embodiments.

As shown in FIGS. 9, 10, and 11, according to one or more embodiments, each of the constant voltage supply lines CVSPL (see FIG. 8) (including VAISPL1 in FIG. 9 and VSSPL in FIG. 10) and the constant voltage bus lines CVBL (see FIG. 8) (including VDBL in FIG. 11) may be located in the first source-drain conductive layer SDCDL1 (see FIG. 7) on the interlayer insulating layer 124.

The first connection portion CNP1 (see FIG. 8, including CNP13 in FIG. 9, CNP12 in FIG. 10, and CNP12, CNP13, CNP14, CNP15, CNP16, and CNP17 in FIG. 11) of each of the constant voltage connection lines CVCL (see FIG. 8, including VAICL1 in FIG. 9, VSCL in FIG. 10, and VRCL, VGICL, VAICL1, VAICL2, VAICL3, and VSCL in FIG. 11) may be included in the second gate conductive layer GCDL2 (see FIG. 7) located on the second gate-insulating layer 123 and covered with the interlayer insulating layer 124.

The second connection portion CNP2 (see FIG. 8, including CNP23 in FIG. 9, CNP22 in FIG. 10, and CNP22, CNP23, CNP24, CNP25, CNP26, and CNP27 in FIG. 11) of each of the constant voltage connection lines CVCL (see FIG. 8, including VAICL1 in FIG. 9, VSCL in FIG. 10, and VRCL, VGICL, VAICL1, VAICL2, VAICL3, and VSCL in FIG. 11) may be located in the second source-drain conductive layer SDCDL2 (see FIG. 7) on the first planarization layer 125 covering the first source-drain conductive layer SDCDL1 (see FIG. 7).

According to one or more embodiments, the data supply lines DTSPL may be located in the first gate conductive layer GCDL1 (see FIG. 7) on the first gate-insulating layer 122.

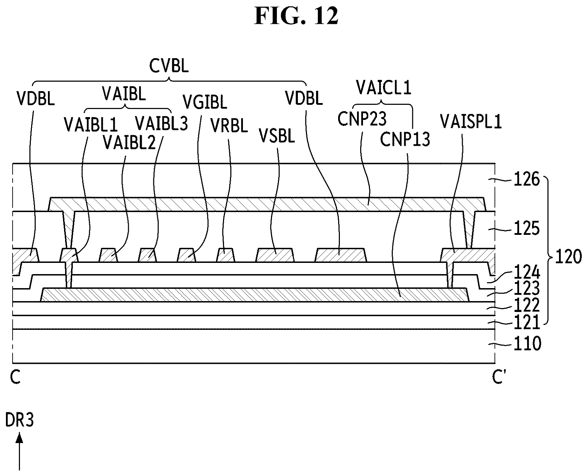

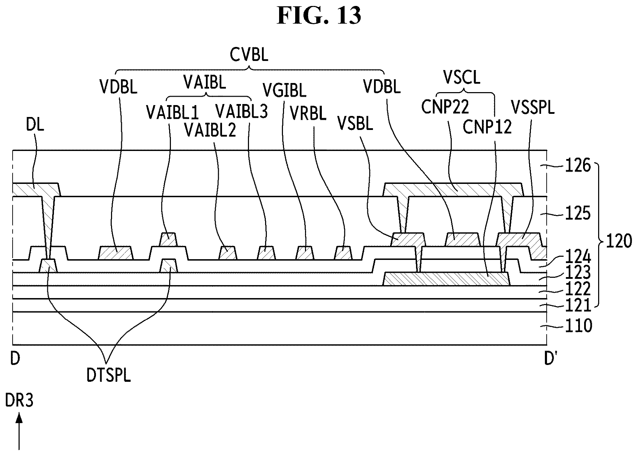

FIG. 12 is a cross-sectional view taken along the line C-C' of FIG. 8 according to one or more embodiments. FIG. 13 is a cross-sectional view taken along the line D-D' of FIG. 8 according to one or more embodiments.

The display panel 100 of the one or more embodiments corresponding to FIGS. 12 and 13 is substantially the same as or similar to the one or more embodiments corresponding to FIGS. 9, 10, and 11, except that the data supply lines DTSPL are located in the second gate conductive layer GCDL2 (see FIG. 7) located on the second gate-insulating layer 123 and covered with the interlayer insulating layer 124, and the first connection portion CNP1 (see FIG. 8, including CNP13 in FIG. 12 and CNP12 in FIG. 13) of each of the constant voltage connection lines CVCL (see FIG. 8, including VAICL1 in FIG. 12 and VSCL in FIG. 13) is included in the first gate conductive layer GCDL1 (see FIG. 7) located on the first gate-insulating layer 122 and covered with the second gate-insulating layer 123, so redundant descriptions will be omitted below.

According to the embodiments shown in FIGS. 9, 10, 11, 12, and 13, the data supply lines DTSPL may be located in either one of the first gate conductive layer GCDL1 (see FIG. 7) or the second gate conductive layer GCDL2 (see FIG. 7) located below the interlayer insulating layer 124, and the first connection portion CNP1 (see FIG. 8) of each of the constant voltage connection lines CVCL (see FIG. 8) may be located in the other one of the first gate conductive layer GCDL1 (see FIG. 7) or the second gate conductive layer GCDL2 (see FIG. 7).

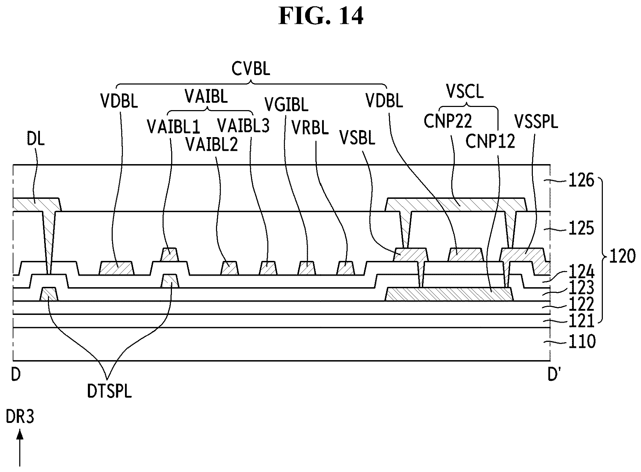

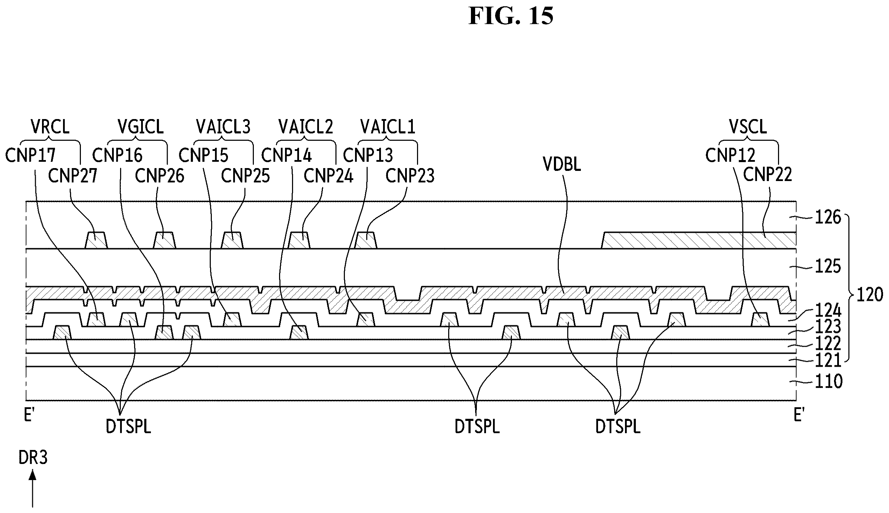

FIG. 14 is a cross-sectional view taken along the line D-D' of FIG. 8 according to one or more embodiments. FIG. 15 is a cross-sectional view taken along the line E-E' of FIG. 8 according to one or more embodiments.

The display panel 100 of the one or more embodiments corresponding to FIGS. 14 and 15 is substantially the same as or similar to the embodiments shown in FIGS. 9, 10, 11, 12, and 13, except that the data supply lines DTSPL and the first connection portion CNP1 (see FIG. 8) of each of the constant voltage connection lines CVCL (see FIG. 8) are located in the first gate conductive layer GCDL1 (see FIG. 7) or the second gate conductive layer GCDL2 (see FIG. 7) located below the interlayer insulating layer 124, so redundant descriptions will be omitted below.

According to the one or more embodiments corresponding to FIGS. 14 and 15, each of the data supply lines DTSPL may be located in the first gate conductive layer GCDL1 (see FIG. 7) or the second gate conductive layer GCDL2 (see FIG. 7).

The first connection portion CNP1 (see FIG. 8, including CNP12 in FIG. 14, and CNP12, CNP13, CNP14, CNP15, CNP16, and CNP17 in FIG. 15) of each of the constant voltage connection lines CVCL (see FIG. 8) may be spaced apart from the data supply lines DTSPL and located in the first gate conductive layer GCDL1 (see FIG. 7) or the second gate conductive layer GCDL2 (see FIG. 7).

In this configuration, because at least some of the data supply lines DTSPL may be adjacently located in the same layer as the first connection portion CNP1 (see FIG. 8, including CNP12 in FIG. 14, and CNP12, CNP13, CNP14, CNP15, CNP16, and CNP17 in FIG. 15) of each of the constant voltage connection lines CVCL (see FIG. 8) transmitting a constant voltage, poor signal coupling between the data supply lines DTSPL may be reduced.

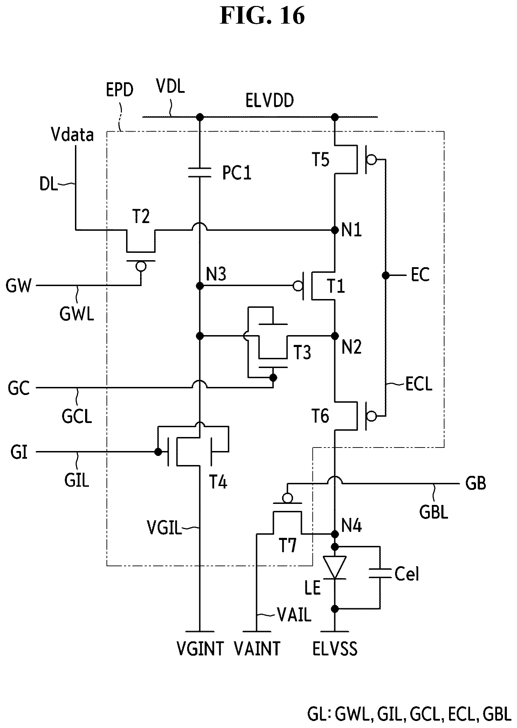

FIG. 16 is an equivalent circuit diagram showing the light-emitting pixel driver of FIG. 5 according to one or more embodiments.

The display panel 100 of the one or more embodiments corresponding to FIG. 16 is substantially the same as or similar to the one or more embodiments corresponding to FIG. 6, except that in each of the light-emitting pixel drivers EPD of the circuit layer 120, the third transistor T3 and the fourth transistor T4 are formed as N-type MOSFETs, the gate electrode of the third transistor T3 is electrically connected to the gate control line GCL for transmitting the gate control signal GC, and the gate electrode of the seventh transistor T7 is electrically connected to a bias control line GBL for transmitting a bias control signal GB, so redundant descriptions will be omitted below.

According to the one or more embodiments corresponding to FIG. 16, in each light-emitting pixel driver EPD, the first transistor T1, the second transistor T2, the fifth transistor T5, the sixth transistor T6, and the seventh transistor T7 may be formed as P-type MOSFETs, while the third transistor T3 and the fourth transistor T4 may be formed as N-type MOSFETs.

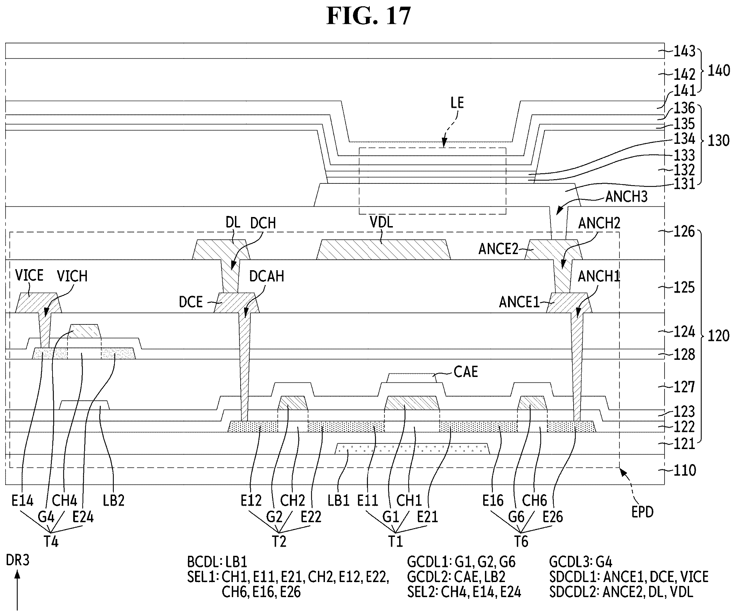

Accordingly, the circuit layer 120 may include the first semiconductor layer SEL1 (see FIG. 17) for forming the P-type MOSFETs, and a second semiconductor layer SEL2 (see FIG. 17) for forming the N-type MOSFETs.

FIG. 17 is a cross-sectional view showing the first transistor, the second transistor, the fourth transistor, the sixth transistor, and the light-emitting element of FIG. 16 according to one or more embodiments.

The display panel 100 of the one or more embodiments corresponding to FIG. 17 is substantially the same as or similar to the one or more embodiments corresponding to FIG. 7, except that the circuit layer 120 further includes an additional interlayer insulating layer 127, the second semiconductor layer SEL2, a third gate-insulating layer 128, and a third gate conductive layer GCDL3 located between the second gate conductive layer GCDL2 on the second gate-insulating layer 123 and the interlayer insulating layer 124, so redundant descriptions will be omitted below.

According to one or more embodiments, the circuit layer 120 may further include the additional interlayer insulating layer 127 covering the second gate conductive layer GCDL2, the second semiconductor layer SEL2 located on the additional interlayer insulating layer 127, the third gate-insulating layer 128 covering the second semiconductor layer SEL2, and the third gate conductive layer GCDL3 located on the third gate-insulating layer 128.

The interlayer insulating layer 124 may cover the third gate conductive layer GCDL3.

According to one or more embodiments, each of the additional interlayer insulating layer 127 and the third gate-insulating layer 128 may include an inorganic insulating material.

The channel portions CH1, CH2, and CH6, the first electrode portions E11, E12, and E16, and the second electrode portions E21, E22, and E26 of the first transistor T1, the second transistor T2, and the sixth transistor T6, respectively, may be located in the first semiconductor layer SEL1.

The first electrode portion E11 of the first transistor T1 may be connected to the second electrode portion E22 of the second transistor T2.

The second electrode portion E21 of the first transistor T1 may be connected to the first electrode portion E16 of the sixth transistor T6.

According to one or more embodiments, the circuit layer 120 may further include a first light-blocking layer LB1 located in a light-blocking conductive layer BCDL on the substrate 110 and overlapping the channel portion CH1 of the first transistor T1.

The buffer layer 121 may cover the light-blocking conductive layer BCDL.

The gate electrode G1 of the first transistor T1, the gate electrode G2 of the second transistor T2, and the gate electrode G6 of the sixth transistor T6 may be located in the first gate conductive layer GCDL1.

As shown in FIG. 16, because the fifth transistor T5 and the seventh transistor T7 of the light-emitting pixel driver EPD are P-type MOSFETs, they may include the same or similar structure as the first transistor T1, the second transistor T2, and the sixth transistor T6. Accordingly, redundant description will be omitted below.

The second gate conductive layer GCDL2 may include a capacitor electrode CAE.

A channel portion CH4, a first electrode portion E14, and a second electrode portion E24 of the fourth transistor T4 may be located in the second semiconductor layer SEL2. A gate electrode G4 of the fourth transistor T4 may be located in the third gate conductive layer GCDL3.

The circuit layer 120 may further include a second light-blocking layer LB2 located in the second gate conductive layer GCDL2 and overlapping the channel portion CH4 of the fourth transistor T4. The channel portion CH4 of the fourth transistor T4 may be interposed between the second light-blocking layer LB2 and the gate electrode G4 of the fourth transistor T4 in the third direction DR3. Accordingly, the second light-blocking layer LB2 may not be in a floating state, but instead may serve as an auxiliary gate electrode of the fourth transistor T4.

Because the third transistor T3 is an N-type MOSFET, it may include the same or similar structure as the fourth transistor T4. Accordingly, redundant description will be omitted below.

The first source-drain conductive layer SDCDL1 may include the first anode connection electrode ANCE1, a data connection electrode DCE, and an initialization connection electrode VICE.

The first anode connection electrode ANCE1 may be electrically connected to the second electrode portion E26 of the sixth transistor T6 through the first anode connection hole ANCH1.

The data connection electrode DCE may be electrically connected to the first electrode portion E12 of the second transistor T2 through a data connection auxiliary hole DCAH.

The initialization connection electrode VICE may be electrically connected to the first electrode portion E14 of the fourth transistor T4 through an initialization connection hole VICH.

The second source-drain conductive layer SDCDL2 may include the second anode connection electrode ANCE2, the data line DL, and the first power line VDL.

The second anode connection electrode ANCE2 may be electrically connected to the first anode connection electrode ANCE1 through the second anode connection hole ANCH2.

The first electrode 131 of the element layer 130 may be located on the second planarization layer 126, and may be electrically connected to the second anode connection electrode ANCE2 through the third anode connection hole ANCH3.

Accordingly, the first electrode 131 may be electrically connected to the second electrode portion E26 of the sixth transistor T6 through the first anode connection electrode ANCE1 and the second anode connection electrode ANCE2.

The data line DL may be electrically connected to the data connection electrode DCE through the data connection hole DCH. Accordingly, the data line DL may be electrically connected to the first electrode portion E12 of the second transistor T2 through the data connection electrode DCE.

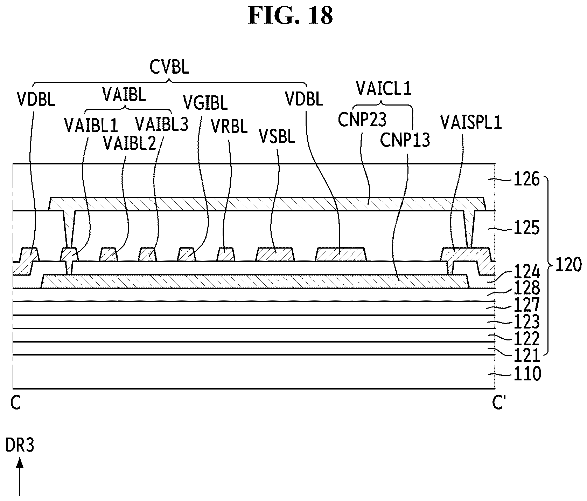

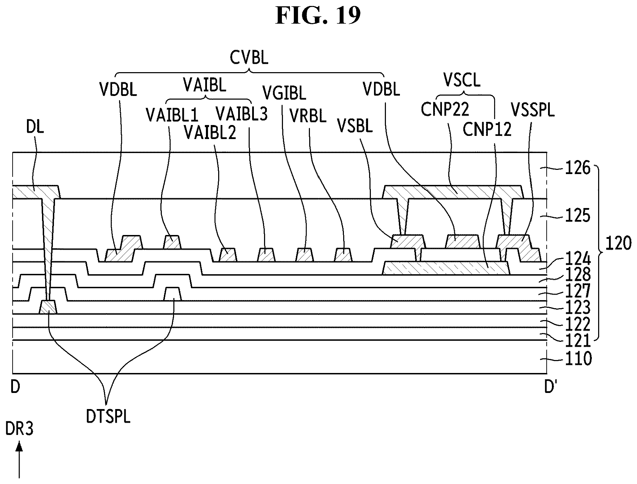

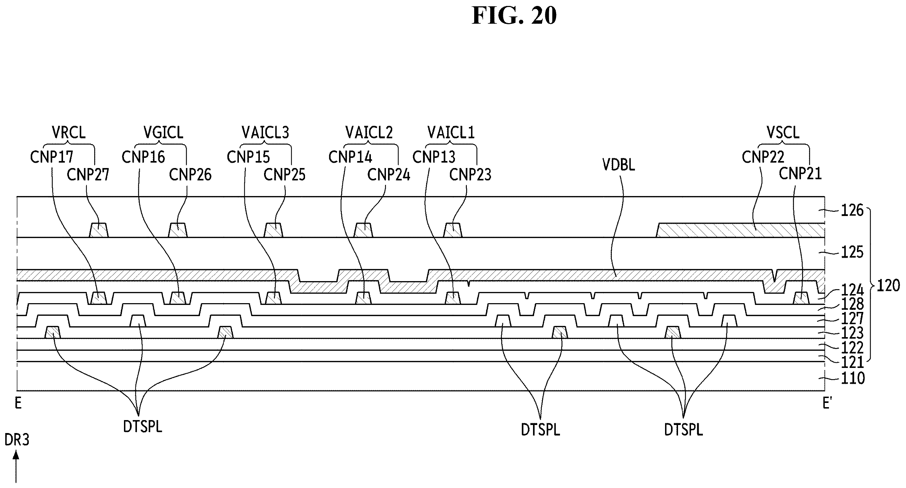

FIG. 18 is a cross-sectional view taken along the line C-C' of FIG. 8 according to one or more embodiments. FIG. 19 is a cross-sectional view taken along the line D-D' of FIG. 8 according to one or more embodiments. FIG. 20 is a cross-sectional view taken along the line E-E' of FIG. 8 according to one or more embodiments.

The display panel 100 of the one or more embodiments corresponding to FIGS. 18, 19, and 20 is substantially the same as or similar to the one or more embodiments corresponding to FIGS. 14 and 15, except that each of the data supply lines DTSPL is located in the first gate conductive layer GCDL1 (see FIG. 7) or the second gate conductive layer GCDL2 (see FIG. 7), and the first connection portion CNP1 (see FIG. 8, including CNP13 in FIG. 18, CNP12 in FIG. 19, and CNP12, CNP13, CNP14, CNP15, CNP16, and CNP17 in FIG. 20) of each of the constant voltage connection lines CVCL (see FIG. 8, including VAICL1 in FIG. 18, VSCL in FIG. 19, and VRCL, VGICL, VAICL1, VAICL2, VAICL3, and VSCL in FIG. 20) is included in the third gate conductive layer GCDL3 located on the third gate-insulating layer 128 and covered with the interlayer insulating layer 124, so redundant descriptions will be omitted below.

In this way, because the first connection portion CNP1 (see FIG. 8, including CNP13 in FIG. 18, CNP12 in FIG. 19, and CNP12, CNP13, CNP14, CNP15, CNP16, and CNP17 in FIG. 20) of each of the constant voltage connection lines CVCL (see FIG. 8, including VAICL1 in FIG. 18, VSCL in FIG. 19, and VRCL, VGICL, VAICL1, VAICL2, VAICL3, and VSCL in FIG. 20) is located in the conductive layer different from that of the data supply lines DTSPL, short circuit failures between the constant voltage connection lines CVCL (see FIG. 8, including VAICL1 in FIG. 18, VSCL in FIG. 19, and VRCL, VGICL, VAICL1, VAICL2, VAICL3, and VSCL in FIG. 20) and the data supply lines DTSPL may be reduced.

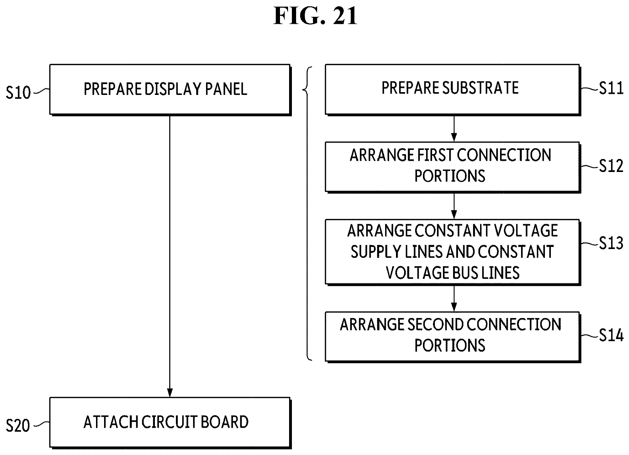

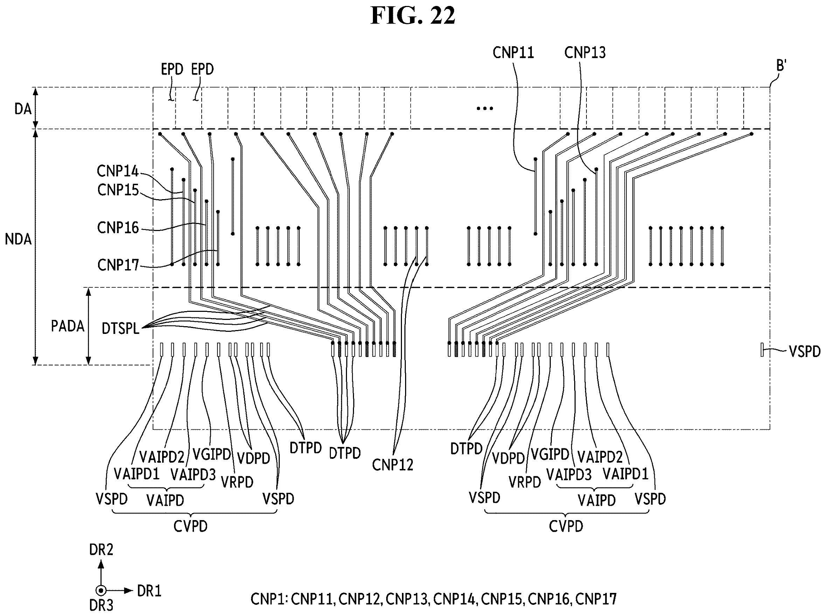

FIG. 21 is a flowchart illustrating a method for manufacturing the display device according to one or more embodiments. FIGS. 22, 23, 24, 25, and 26 are process diagrams illustrating some of the operations of FIG. 21.

Referring to FIG. 21, a method for manufacturing the display device 10 according to one or more embodiments may include an operation S10 of preparing the display panel 100 including the display area DA (see FIG. 4), the non-display area NDA (see FIG. 4), and the pads PAD (see FIG. 4), and an operation S20 of attaching at least one circuit board 200 (see FIG. 3) to the pads PAD (see FIG. 4).

The pads PAD (see FIG. 4) may be located in the pad area PADA (see FIGS. 3 and 4) adjacent to the edge of the substrate 110 (see FIG. 2) in the non-display area NDA, and may be arranged along the edge of the substrate 110 (see FIG. 2).

The operation S10 of preparing the display panel 100 may include an operation S11 of preparing the substrate 110 (see FIG. 2) including the display area DA (see FIG. 4) and the non-display area NDA (see FIG. 4), an operation S12 of arranging the first connection portions CNP1 (see FIG. 8) on the substrate 110 (see FIG. 2), an operation S13 of arranging the constant voltage supply lines CVSPL (see FIG. 8) electrically connected to some of the pads PAD (see FIG. 4) (e.g., constant voltage supply pads CVPD in FIG. 8) in the pad area PADA (see FIG. 8), and arranging the constant voltage bus lines CVBL (see FIG. 8) extending along a part of the edge of the display area DA (see FIG. 8) in a partial area of the non-display area NDA (see FIG. 8) between the pad area PADA (see FIG. 8) and the display area DA (see FIG. 8), and an operation S14 of arranging the second connection portions CNP2 (see FIG. 8) overlapping the first connection portions CNP1 (see FIG. 8) in the thickness direction of the substrate 110 (see FIG. 2) (e.g., third direction DR3) and electrically connected to the first connection portions CNP1 (see FIG. 8).

As shown in FIG. 22, in the operation S12 of arranging the first connection portions CNP1, at least some of the data supply lines DTSPL for transmitting the data signals Vdata (see FIGS. 6 and 16) and respectively electrically connected to some others of the pads PAD (e.g., data supply pads DTPD) may be located in the non-display area NDA together with the first connection portions CNP1.

The data supply lines DTSPL may extend from the pad area PADA to the display area DA.

According to the one or more embodiments corresponding to FIGS. 9, 10, and 11 and the one or more embodiments corresponding to FIGS. 12 and 13, the data supply lines DTSPL may be located in either one of the first gate conductive layer GCDL1 (see FIG. 7) or the second gate conductive layer GCDL2 (see FIG. 7), and the first connection portions CNP1 may be located in the other one of the first gate conductive layer GCDL1 (see FIG. 7) or the second gate conductive layer GCDL2 (see FIG. 7).

According to the one or more embodiments corresponding to FIGS. 14 and 15, each of the data supply lines DTSPL and the first connection portions CNP1 may be located in the first gate conductive layer GCDL1 (see FIG. 7) or the second gate conductive layer GCDL2 (see FIG. 7).

According to the one or more embodiments corresponding to FIGS. 18, 19, and 20, each of the data supply lines DTSPL may be located in the first gate conductive layer GCDL1 (see FIG. 17) or the second gate conductive layer GCDL2 (see FIG. 17), and the first connection portions CNP1 may be located in the third gate conductive layer GCDL3 (see FIG. 17).

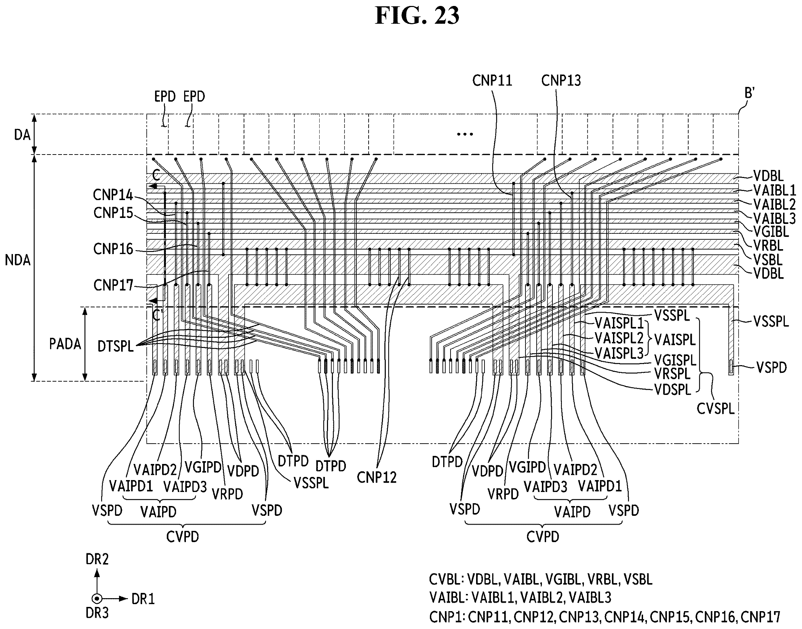

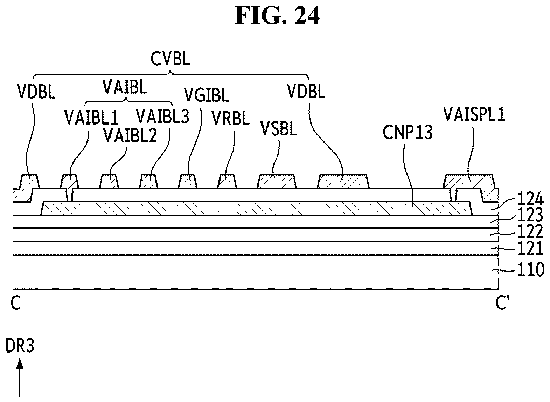

As shown in FIGS. 23 and 24, in the operation S13 of arranging the constant voltage supply lines CVSPL and the constant voltage bus lines CVBL, the constant voltage bus lines CVBL may be electrically connected to the constant voltage supply lines CVSPL through the first connection portions CNP1, respectively.

The constant voltage supply lines CVSPL and the constant voltage bus lines CVBL may be located in the first source-drain conductive layer SDCDL1 (see FIGS. 7 and 17).

In this way, in the operation S13 of arranging the constant voltage supply lines CVSPL and the constant voltage bus lines CVBL, because none of the constant voltage bus lines CVBL is in a floating state in the form of an island, which may be relatively vulnerable to static electricity, the introduced static electricity may be suitably dispersed and discharged, thereby reducing the likelihood of defects that might be caused by concentration of the static electricity.

Therefore, breakage or damage of the constant voltage bus lines CVBL due to the static electricity may be reduced or prevented, thereby improving the quality reliability and yield of the display device 10.

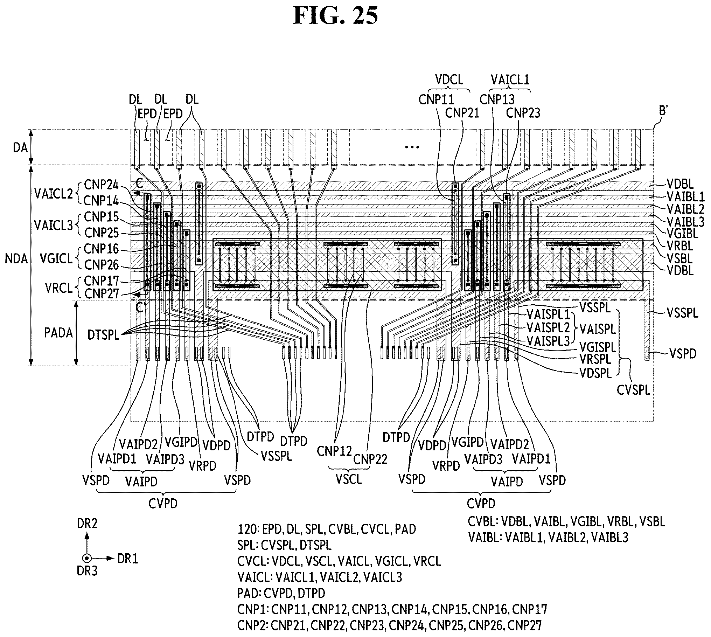

As shown in FIG. 25, in the operation S14 of arranging the second connection portions CNP2, the data lines DL may be located in the display area DA together with the second connection portions CNP2. The data lines DL may be electrically connected to the data supply lines DTSPL, respectively. The second connection portions CNP2 and the data lines DL may be located in the second source-drain conductive layer SDCDL2 (see FIGS. 7 and 17).

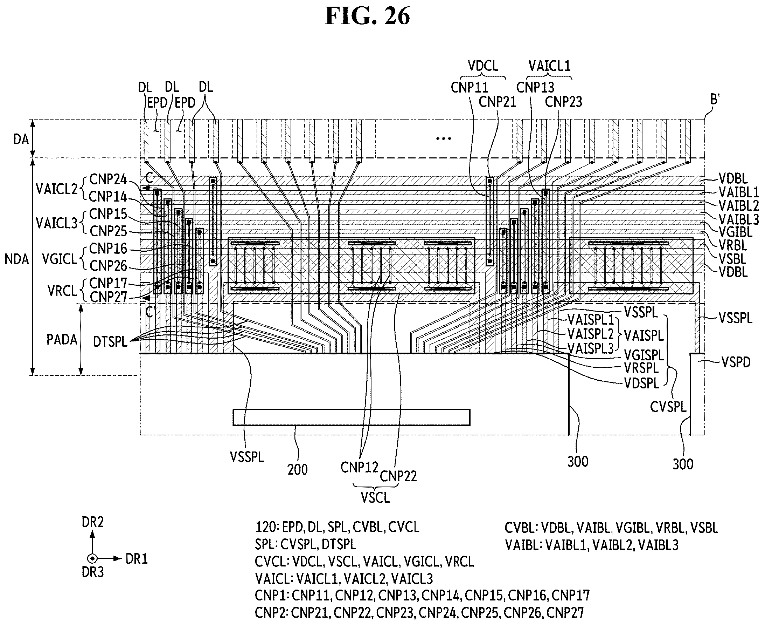

As shown in FIG. 26, in the operation 20 of attaching at least one circuit board 200, the at least one circuit board 200 may be adhered to the pads PAD (see FIG. 25) of the display panel 100 using a low-resistance, high-reliability material, such as an anisotropic conductive film or self-assembly anisotropic conductive paste (SAP).

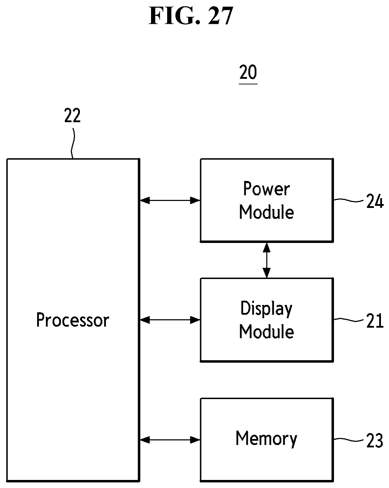

The display device 10 of each embodiment as described above may be applied to various electronic devices 20 (see FIG. 27). The electronic device 20 (see FIG. 27) according to one or more embodiments may include the above-described display device 10. Additionally, the electronic device 20 (see FIG. 27) according to one or more embodiments may further include a module or device having other additional functions in addition to the display device 10.

FIG. 27 is a block diagram of an electronic device according to one or more embodiments.

Referring to FIG. 27, the electronic device 20 according to one or more embodiments may include a display module 21, a processor 22, a memory 23, and a power module 24.

The display module 21 may include the display device 10 that displays an image.

The processor 22 may include at least one of a central processing unit (CPU), an application processor (AP), a graphic processing unit (GPU), a communication processor (CP), an image signal processor (ISP), or a controller.

The memory 23 may store data information suitable for the operation of the processor 22 or the display module 21. When the processor 22 executes an application stored in the memory 23, an image data signal and/or an input control signal is transmitted to the display module 21, and the display module 21 may process the received signal and may output image information through a display screen.

The power module 24 may include a power supply module, such as a power adapter or a battery device, and a power conversion module that converts the power supplied by the power supply module to generate the power suitable for the operation of the electronic device 20.

At least one of the components of the electronic device 20 described above may be included in the display device according to the embodiments described above. Further, some of individual modules functionally included in one module may be included in the display device and some others may be provided separately from the display device. For example, the display device 10 may include the display module 21, and the processor 22, the memory 23, and the power module 24 may be provided in the form of other devices in the electronic device 20 other than the display device 10.

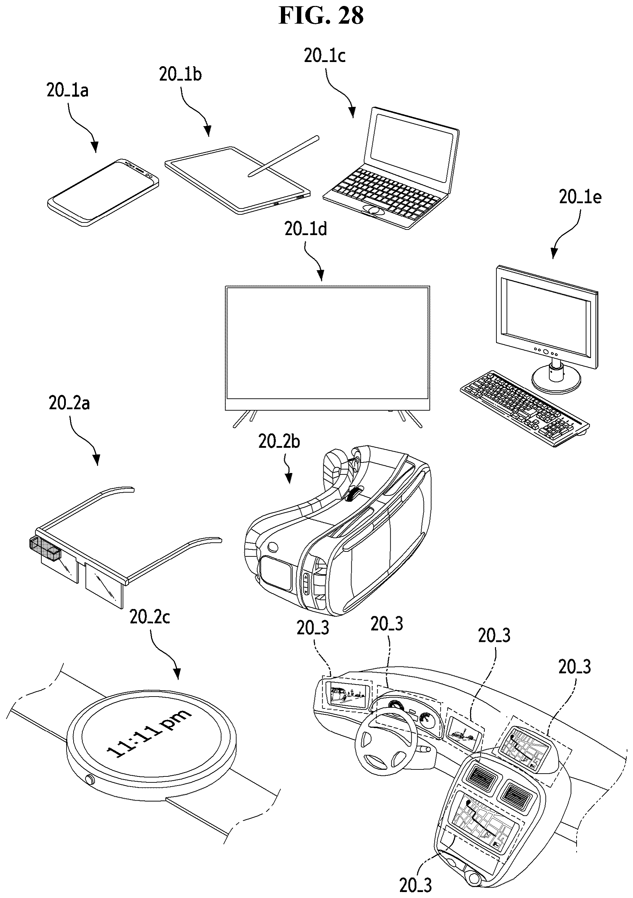

FIG. 28 is schematic views of electronic devices according to various embodiments.

Referring to FIG. 28, the electronic devices 20 according to the embodiments may include not only an image display electronic device, such as a smartphone 20_1a, a tablet PC 20_1b, a laptop 20_1c, a TV 20_1d, and a desk monitor 20_1e, but also a wearable electronic device, such as smart glasses 20_2a, a head mounted display 20_2b, and a smart watch 20_2c, and a vehicle electronic device 20_3, such as a dashboard of a vehicle, a center fascia, a center information display (CID) of the dashboard, and a room mirror display.

However, the aspects of the present disclosure are not restricted to the one set forth herein. The above and other aspects of the present disclosure will become more apparent to one of daily skill in the art to which the present disclosure pertains by referencing the claims, with functional equivalents thereof to be included therein.

## Claims

1. A display device (10) comprising:
a circuit board (200); and
a display panel (100) comprising:
a substrate (110) comprising a display area (DA), and a non-display area (NDA) around the display area; pads (PAD) electrically connected to the circuit board, and arranged in a pad area (PADA) of the non-display area that is adjacent to an edge of the substrate (110); and
a circuit layer (120) on the substrate (110), and comprising:
constant voltage supply lines (CVSPL) in the pad area, configured to transmit a constant voltage, and electrically connected to a part of the pads;
constant voltage bus lines (CVBL) in an area of the non-display area between the pad area and the display area, and extending along an edge of the display area; and
constant voltage connection lines (CVCL) respectively electrically connected between the constant voltage supply lines (CVSPL) and the constant voltage bus lines, and comprising a first connection portion (CNP1) below the constant voltage bus lines (CVBL), and a second connection portion (CNP2) on the constant voltage bus lines (CVBL).

2. The display device (10) of claim 1, wherein the circuit layer (120) comprises:
an interlayer insulating layer (124) on the substrate (110);
a first source-drain conductive layer on the interlayer insulating layer (124);
a first planarization layer (125) covering the first source-drain conductive layer;
a second source-drain conductive layer on the first planarization layer (125); and
a second planarization layer (126) covering the second source-drain conductive layer,
wherein the constant voltage bus lines (CVBL) and the constant voltage supply lines (CVSPL) are in the first source-drain conductive layer, and
wherein the second connection portion (CNP2) is in the second source-drain conductive layer.

3. The display device (10) of claim 1 or 2, wherein the display panel (100) further comprises an element layer (130) on the circuit layer (120) and comprising light-emitting elements, and
wherein the circuit layer (120) further comprises:
light-emitting pixel drivers respectively electrically connected to the light-emitting elements;
data lines in the display area, and configured to transmit a data signal; and
data supply lines in the non-display area, and respectively electrically connected between other part of the pads and the data lines.

4. The display device (10) of any of the preceding claims, wherein the circuit layer (120) further comprises:
a first semiconductor layer (SEL1) on the substrate (110);
a first gate-insulating layer (122) covering the first semiconductor layer;
a first gate conductive layer (GCDL1) on the first gate-insulating layer (122);
a second gate-insulating layer (123) covering the first gate conductive layer; and
a second gate conductive layer (GCDL2) on the second gate-insulating layer (123),
wherein the interlayer insulating layer (124) covers the second gate conductive layer.

5. The display device (10) of claim 3 or 4, wherein the data supply lines are in one of the first gate conductive layer (GCDL1) and the second gate conductive layer (GCDL2), and
wherein the first connection portion (CNP1) is in another one of the first gate conductive layer (GCDL1) and the second gate conductive layer (GCDL2).

6. The display device (10) of claim 4 or 5, wherein the data supply lines are in the first gate conductive layer (GCDL1) or the second gate conductive layer (GCDL1), and
wherein the first connection portion (CNP1) is spaced apart from the data supply lines, and is in the first gate conductive layer (GCDL1) or the second gate conductive layer (GCDL2).

7. The display device (10) of any of claims 3 to 6, wherein the circuit layer (120) further comprises:
a first semiconductor layer on the substrate (110);
a first gate-insulating layer (122) covering the first semiconductor layer;
a first gate conductive layer on the first gate-insulating layer (122);
a second gate-insulating layer (123) covering the first gate conductive layer;
a second gate conductive layer on the second gate-insulating layer (123);
an additional interlayer insulating layer (127) covering the second gate conductive layer;
a second semiconductor layer on the additional interlayer insulating layer (127);
a third gate-insulating layer (128) covering the second semiconductor layer; and
a third gate conductive layer on the third gate-insulating layer (128),
wherein the interlayer insulating layer (124) covers the third gate conductive layer,
wherein the data supply lines are in the first gate conductive layer or the second gate conductive layer, and
wherein the first connection portion (CNP1) is in the third gate conductive layer.

8. A method for manufacturing a display device (10) of any of the preceding claims, the method comprising:
preparing a display panel (100) comprising a display area, a non-display area around the display area, and pads in a pad area of the non-display area; and
attaching a circuit board to the pads,
wherein the preparing of the display panel (100) comprises:
preparing a substrate (110) comprising the display area and the non-display area;
arranging first connection portions (CNP1) on the substrate (110);
arranging constant voltage supply lines (CVSPL) electrically connected to a part of the pads in the pad area;
arranging constant voltage bus lines (CVBL) extending along an edge of the display area in the non-display area between the pad area and the display area; and
arranging second connection portions (CNP2) overlapping the first connection portions in a thickness direction of the substrate (110), and electrically connected to the first connection portions (CNP2).

9. The method of claim 8, wherein the constant voltage bus lines (CVBL) are respectively electrically connected to the constant voltage supply lines (CVSPL) through the first connection portions, and/or further comprising arranging data supply lines configured to transmit data signals in the non-display area with the first connection portions (CNP1), at least a part of the data supply lines being respectively electrically connected to other part of the pads.

10. The method of claim 8 or 9, wherein the display panel (100) comprises:
a first semiconductor layer on the substrate (110);
a first gate-insulating layer (122) covering the first semiconductor layer;
a first gate conductive layer on the first gate-insulating layer (122);
a second gate-insulating layer (123) covering the first gate conductive layer;
a second gate conductive layer on the second gate-insulating layer (123);
an interlayer insulating layer (124) covering the second gate conductive layer;
a first source-drain conductive layer on the interlayer insulating layer (124);
a first planarization layer (125) covering the first source-drain conductive layer;
a second source-drain conductive layer on the first planarization layer (125); and
a second planarization layer (126) covering the second source-drain conductive layer,
wherein the constant voltage bus lines (CVBL) and the constant voltage supply lines (CVSPL) are in the first source-drain conductive layer, and
wherein the second connection portions are in the second source-drain conductive layer.

11. The method of claim 10, wherein the data supply lines are in one of the first gate conductive layer and the second gate conductive layer, and
wherein the first connection portions (CNP1) are in the other one of the first gate conductive layer and the second gate conductive layer.

12. The method of claim 10 or 11, wherein the data supply lines are in the first gate conductive layer or the second gate conductive layer, and
wherein the first connection portions (CNP1) are spaced apart from the data supply lines in the first gate conductive layer or the second gate conductive layer.

13. The method of any of claims 9 to 12, wherein the preparing of the display panel (100) further comprises arranging data supply lines configured to transmit data signals in the non-display area (NDA), extending from the pad area to the display area, and electrically connected to other part of the pads.

14. The method of claim 13, wherein the display panel (100) comprises:
a first semiconductor layer on the substrate (110);
a first gate-insulating layer (122) covering the first semiconductor layer;
a first gate conductive layer on the first gate-insulating layer (122);
a second gate-insulating layer (123) covering the first gate conductive layer;
a second gate conductive layer on the second gate-insulating layer (123);
an additional interlayer insulating layer (127) covering the second gate conductive layer;
a second semiconductor layer on the additional interlayer insulating layer (127);
a third gate-insulating layer (128) covering the second semiconductor layer;
a third gate conductive layer on the third gate-insulating layer (128);
an interlayer insulating layer (124) covering the third gate conductive layer;
a first source-drain conductive layer on the interlayer insulating layer (124);
a first planarization layer (125) covering the first source-drain conductive layer;
a second source-drain conductive layer on the first planarization layer (125); and
a second planarization layer (126) covering the second source-drain conductive layer,
wherein the constant voltage bus lines (CVBL) and the constant voltage supply lines (CVSPL) are in the first source-drain conductive layer,
wherein the second connection portions (CNP2) are in the second source-drain conductive layer,
wherein the data supply lines are in the first gate conductive layer or the second gate conductive layer, and
wherein the first connection portions (CNP1) are in the third gate conductive layer.

15. An electronic device comprising:
a display device (10) of any of claims 1 to 7, the display device being for displaying an image;
a memory (23) for storing an application;
a processor (22) for executing the application, and configured to transmit an image data signal and an input control signal to the display device (10); and a power module (24) configured to transmit power to the display device (10).
